(19) Europäisches Patentamt / European Patent Office / Office européen des brevets

(11) **EP 4 444 063 A1**

(12) **EUROPEAN PATENT APPLICATION**
published in accordance with Art. 153(4) EPC

(43) Date of publication:
**09.10.2024 Bulletin 2024/41**

(51) International Patent Classification (IPC):
**H10K 59/00** (2023.01)   **H10K 50/00** (2023.01)
**H10K 50/80** (2023.01)

(21) Application number: **22946139.7**

(22) Date of filing: **14.06.2022**

(86) International application number:
**PCT/CN2022/098636**

(87) International publication number:
**WO 2023/240440 (21.12.2023 Gazette 2023/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Boe Technology Group Co., Ltd.**
**Beijing 100015 (CN)**
• **Chengdu BOE Optoelectronics Technology Co.,
Ltd.**
**Chengdu, Sichuan 611731 (CN)**

(72) Inventors:
• **GUI, Bingqiang**
**Beijing 100176 (CN)**
• **GAO, Tao**
**Beijing 100176 (CN)**
• **HUANG, Yao**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND MANUFACTURING METHOD THEREFOR, AND DISPLAY DEVICE**

(57) A display substrate comprises a base substrate (101) and a drive circuit layer (102) provided on the base substrate (101). The drive circuit layer (102) comprises at least one pixel circuit, and the pixel circuit comprises at least one oxide thin film transistor and a capacitor (C). The capacitor (C) comprises a first capacitive plate (381) and a second capacitive plate (382). There is an overlap between orthographic projections of the first capacitive plate (381) and the second capacitive plate (382) on the base substrate (101), and an inorganic insulating layer is provided between the first capacitive plate (381) and the second capacitive plate (382). In a direction perpendicular to the display substrate, the distance between the inorganic insulating layer and an active layer of the oxide thin film transistor is greater than or equal to 3000 angstroms.

FIG. 6A

**Description**

Technical Field

The present disclosure relates to, but is not limited to, the field of display technologies, and particularly to a display substrate and a preparing method thereof, and a display apparatus.

Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, bendability, and a low cost, etc.

Summary

The following is a summary of subject matters described herein in detail. The summary is not intended to limit the protection scope of claims.

Embodiments of the present disclosure provide a display substrate and a preparing method thereof, and a display apparatus.

In an aspect, an embodiment of the present disclosure provides a display substrate, including: a base substrate and a drive circuit layer disposed on the base substrate. The drive circuit layer includes at least one pixel circuit, wherein the at least one pixel circuit includes at least one oxide thin film transistor and a capacitor. The capacitor includes a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate. In a direction perpendicular to the display substrate, a distance between the inorganic insulation layer and an active layer of the oxide thin film transistor is greater than or equal to 3000 angstroms.

In some exemplary embodiments, a material of the active layer of the oxide thin film transistor includes an indium gallium zinc oxide material.

In some exemplary embodiments, a material of the inorganic insulation layer includes silicon nitride SiNx.

In some exemplary embodiments, the pixel circuit includes a drive transistor, the first capacitor plate of the capacitor is equipotential to a gate of the drive transistor, and the second capacitor plate of the capacitor is electrically connected with an anode of a light emitting element.

In some exemplary embodiments, the drive circuit layer at least includes: a first conductive layer, a second conductive layer, and a semiconductor layer that are sequentially disposed on the base substrate. The semiconductor layer includes: an active layer of the at least one oxide thin film transistor. The first conductive layer at least includes: the first capacitor plate. The second conductive layer at least includes: the second capacitor plate.

In some exemplary embodiments, the first conductive layer is a light shielding layer.

In some exemplary embodiments, a third insulation layer is disposed between the second conductive layer and the semiconductor layer, wherein a material of the third insulation layer includes silicon oxide SiOx, and a thickness of the third insulation layer is substantially 3500 angstroms to 4500 angstroms.

In some exemplary embodiments, the drive circuit layer further includes: a third conductive layer located at a side of the semiconductor layer away from the base substrate, wherein the third conductive layer includes a gate of the at least one oxide thin film transistor.

In some exemplary embodiments, the drive circuit layer includes: a semiconductor layer, a second conductive layer, a fourth conductive layer, and a fifth conductive layer that are sequentially disposed on the base substrate. The semiconductor layer includes: an active layer of the at least one oxide thin film transistor. The second conductive layer includes: a gate of the at least one oxide thin film transistor. The fourth conductive layer at least includes: the first electrode plate. The fifth conductive layer at least includes: the second electrode plate.

In some exemplary embodiments, a fifth insulation layer is disposed between the fourth conductive layer and the second conductive layer, a material of the fifth insulation layer includes silicon oxide SiOx, and a thickness of the fifth insulation layer is substantially 4500 angstroms to 5500 angstroms.

In some exemplary embodiments, the drive circuit layer further includes: a first conductive layer located at a side of the semiconductor layer close to the base substrate. The first conductive layer includes: at least one light shielding electrode, wherein an orthographic projection of the light shielding electrode on the base substrate covers an orthographic projection of a channel region of the active layer of the oxide thin film transistor on the base substrate.

In some exemplary embodiments, the inorganic insulation layer and an organic insulation layer are disposed between the fourth conductive layer and the fifth conductive layer, wherein the inorganic insulation layer is located at a side of the organic insulation layer close to the base substrate. An overlapping region of the first capacitor plate and the second capacitor plate is not overlapped with an orthographic projection of the organic insulation layer on the base substrate.

In some exemplary embodiments, the fifth conductive layer further includes: a data signal line and a first power supply line.

In some exemplary embodiments, the at least one oxide thin film transistor includes a drive transistor; and a gate of the drive transistor is electrically connected with the first capacitor plate of the capacitor. An orthographic projection of a channel region of an active layer of the drive transistor on the base substrate is overlapped with each of orthographic projections of the first capacitor plate and the second capacitor plate of the capacitor on the base substrate.

In another aspect, an embodiment of the present disclosure provides a display apparatus, which includes the aforementioned display substrate.

In another aspect, an embodiment of the present disclosure provides a method for a preparing a display substrate, which is used for preparing the above-mentioned display substrate. The method for preparing includes: forming a drive circuit layer on a base substrate, wherein the drive circuit layer includes at least one pixel circuit, and the at least one pixel circuit includes at least one oxide thin film transistor and a capacitor; the capacitor includes a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate; a distance between the inorganic insulation layer and an active layer of the oxide thin film transistor is greater than or equal to 3000 angstroms in a direction perpendicular to the display substrate.

Other aspects may be understood upon reading and understanding the drawings and the detailed description.

Brief Description of Drawings

Accompanying drawings are used for providing further understanding of technical solutions of the present disclosure, constitute a part of the specification, and together with the embodiments of the present disclosure, are used for explaining the technical solutions of the present disclosure but not to constitute limitations on the technical solutions of the present disclosure. Shapes and sizes of one or more components in the drawings do not reflect true scales, but are only intended to schematically describe contents of the present disclosure.

FIG. 1 is a schematic diagram of a structure of a display apparatus.

FIG. 2 is a schematic diagram of a structure of a display substrate.

FIG. 3 is a schematic diagram of a cross-sectional structure of a display region of a display substrate.

FIG. 4 is an equivalent circuit diagram of a pixel circuit according to at least one embodiment of the present disclosure.

FIG. 5 is a schematic partial top diagram of a drive circuit layer according to at least one embodiment of the present disclosure.

FIG. 6A is a partial sectional view along a P-P' direction in FIG. 5.

FIG. 6B is a partial sectional view along a Q-Q' direction in FIG. 5.

FIG. 7A is a partially enlarged schematic diagram of a drive circuit layer after a first conductive layer is formed in FIG. 5.

FIG. 7B is a partially enlarged schematic diagram of a drive circuit layer after a second conductive layer is formed in FIG. 5.

FIG. 7C is a partially enlarged schematic diagram of a drive circuit layer after a semiconductor layer is formed in FIG. 5.

FIG. 7D is a partially enlarged schematic diagram of the drive circuit layer after a third conductive layer is formed in FIG. 5.

FIG. 7E is a partially enlarged schematic diagram of the drive circuit layer after a fifth insulation layer is formed in FIG. 5.

FIG. 7F is a partially enlarged schematic diagram of the drive circuit layer after a fourth conductive layer is formed in FIG. 5.

FIG. 8A is another schematic partial top diagram of a drive circuit layer according to at least one embodiment of the present disclosure.

FIG. 8B is a partially enlarged schematic diagram of the drive circuit layer after a fourth conductive layer is formed in FIG. 8A.

FIG. 8C is a partially enlarged schematic diagram of the drive circuit layer after a semiconductor layer is formed in FIG. 8A.

FIG. 9 is another schematic partial top diagram of a drive circuit layer according to at least one embodiment of the present disclosure.

FIG. 10 is a partial sectional view along an R-R' direction in FIG. 9.

FIG. 11A is a partially enlarged schematic diagram of the drive circuit layer after a first conductive layer is formed in FIG. 9.

FIG. 11B is a partially enlarged schematic diagram of the drive circuit layer after a semiconductor layer is formed in FIG. 9.

FIG. 11C is a partially enlarged schematic diagram of the drive circuit layer after a second conductive layer is formed in FIG. 9.

FIG. 11D is a partially enlarged schematic diagram of the drive circuit layer after a fifth insulation layer is formed in FIG. 9.

FIG. 11E is a partially enlarged schematic diagram of the drive circuit layer after a fourth conductive layer is formed in FIG. 9.

FIG. 11F is a partially enlarged schematic diagram of the drive circuit layer after a seventh insulation layer is formed in FIG. 9.

Detailed Description

The embodiments of the present disclosure will be described below in combination with the drawings in detail. Implementations may be implemented in multiple different forms. Those of ordinary skill in the art may easily understand such a fact that manners and contents may be transformed into other forms without departing from the purpose and scope of the present disclosure. Therefore, the present disclosure should not be explained as being limited to contents described in following implementation modes only. The embodiments in the present disclosure and features in the embodiments may be combined randomly with each other without conflict.

In the drawings, a size of one or more constituent elements, a thickness of a layer, or a region is sometimes exaggerated for clarity. Therefore, a mode of the present disclosure is not necessarily limited to the size, and a shape and a size of one or more components in the drawings do not reflect a true proportion. In addition, the drawings schematically illustrate ideal examples, and one implementation of the present disclosure is not limited to the shapes, numerical values, or the like shown in the drawings.

Ordinal numerals such as "first", "second", and "third" in the specification are set to avoid confusion of constituent elements, but not to set a limit in quantity. In the present disclosure, "multiple" represents two or more than two.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred apparatus or element must have a particular orientation and be constructed and operated in the particular orientation. Therefore, they cannot be understood as limitations on the present disclosure. The positional relationships between the constituent elements vary as appropriate according to a direction where the constituent elements are described. Therefore, appropriate replacements may be made according to situations without being limited to the wordings described in the specification.

In the specification, unless otherwise specified and defined explicitly, terms "mount", "mutually connect", and "connect" should be understood in a broad sense. For example, it may be a fixed connection, a detachable connection, or an integrated connection; it may be a mechanical connection or a connection; it may be a direct connection, an indirect connection through an intermediate component, or communication inside two components. Those of ordinary skills in the art may understand meanings of the above-mentioned terms in the present disclosure according to situations.

In the specification, "electrical connection" includes a case that constituent elements are connected together through an element with a certain electrical effect. "An element with a certain electrical effect" is not particularly limited as long as electrical signals between the connected constituent elements may be transmitted. Examples of "an element with a certain electrical effect" not only include an electrode and a wiring, but further include a switch element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain electrode (drain electrode terminal, drain region, or drain) and the source electrode (source electrode terminal, source region, or source), and a current may flow through the drain electrode, the channel region, and the source electrode. In the specification, the channel region refers to a region through which a current mainly flows.,

In the specification, a first electrode may be a drain electrode and a second electrode may be a source electrode, or, a first electrode may be a source electrode and a second electrode may be a drain electrode. In a case that transistors with opposite polarities are used, or in a case that a direction of a current changes during work of a circuit, or the like, functions of the "source electrode" and the "drain electrode" may sometimes be exchangeable. Therefore, the "source electrode" and the "drain electrode" may be exchangeable in the specification. In addition, the gate may also be referred to as a control electrode.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In this specification, a triangle, a rectangle, a trapezoid, a pentagon, or a hexagon, etc., is not strictly defined, and it may be approximately a triangle, a rectangle, a trapezoid, a pentagon, or a hexagon, etc. There may be some small deformations caused by tolerances, and there may be a chamfer, an arc edge, and a deformation, etc.

In the present disclosure, "about" and "substantially" refer to a case that a boundary is not defined strictly and a process and measurement error within a range is allowed. In the present disclosure, "substantially the same" is a case where values differ by less than 10%.

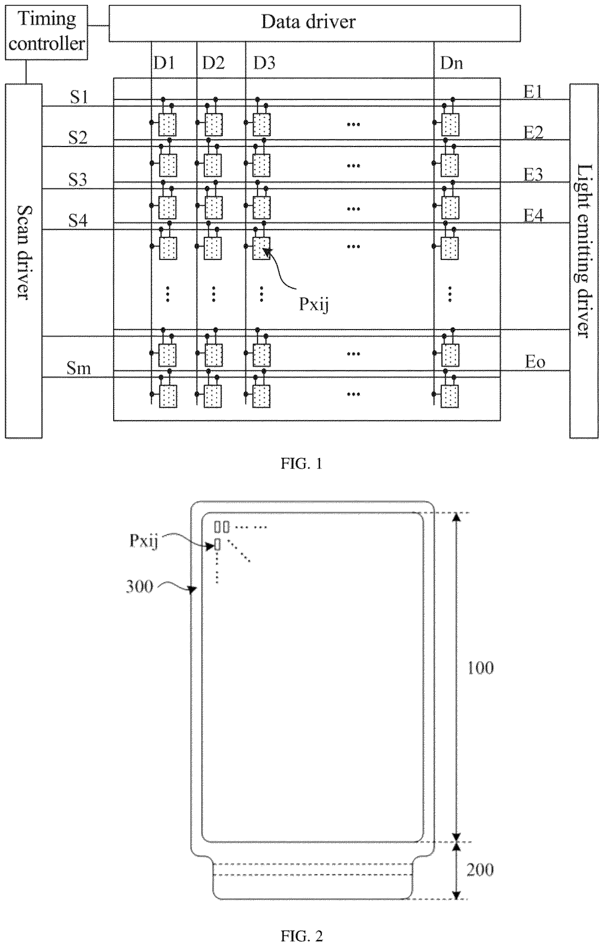

FIG. 1 is a schematic diagram of a structure of a display apparatus. As shown in FIG. 1, the display apparatus may include: a timing controller, a data driver, a scan driver, a light emitting driver, and a pixel array. The timing controller is respectively connected with the data driver, the scan driver and the light emitting driver. The data driver is respectively connected with multiple data signal lines (e.g. D1 to Dn), the scan driver is respectively connected with multiple scan signal lines (e.g. S1 to Sm), and the light emitting driver is respectively connected with multiple light emitting control lines (e.g. E1 to Eo). Among them, n, m, and o are all natural numbers. The pixel array may include multiple sub-pixels Pxij, wherein i and j may be natural numbers. At least one sub-pixel Pxij may include: a pixel circuit and a light emitting element connected with the pixel circuit. The pixel circuit may be respectively connected with a scan signal line, a light emitting control line, and a data signal line.

In some exemplary embodiments, the timing controller may provide a gray-scale value and a control signal, which are suitable for a specification of the data driver, to the data driver, provide a clock signal, a scan start signal, etc., which are suitable for a specification of the scan driver, to the scan driver, and provide a clock signal, a transmit stop signal, etc., which are suitable for a specification of the light emitting driver, to the light emitting driver. The data driver may generate a data voltage to be provided to the data signal lines D1, D2, D3, ..., and Dn by using the gray-scale value and the control signal that are received from the timing controller. For example, the data driver may sample the gray-scale value by using the clock signal, and apply a data voltage corresponding to the gray-scale value to the data signal lines D1 to Dn by taking a pixel row as a unit. The scan driver may generate a scan signal to be provided to the scan signal lines S1, S2, S3, ..., and Sm by receiving the clock signal, the scan start signal, etc., from the timing controller. For example, the scan driver may provide a scan signal with an on-level pulse to the scan signal lines S1 to Sm sequentially. For example, the scan driver may be constructed in a form of a shift register, and may generate the scan signal by sequentially transmitting the scan start signal provided in a form of the on-level pulse to a next-stage circuit under controlling of the clock signal. The light emitting driver may generate a light emitting control signal to be provided to the light emitting control lines E1, E2, E3, ..., and Eo by receiving the clock signal, the transmit stop signal, etc., from the timing controller. For example, the light emitting driver may sequentially provide a transmit signal with an off-level pulse to the light emitting control lines E1 to Eo. For example, the light emitting driver may be constructed in a form of the shift register, and generate a light emitting control signal by sequentially transmitting the transmit stop signal provided in a form of the off-level pulse to a next-stage circuit under controlling of the clock signal.

FIG. 2 is a schematic diagram of a structure of a display substrate. As shown in FIG. 2, the display substrate may include a display region 100, a bonding region 200 at a side of the display region 100, and a bezel region 300 at other sides of the display region 100. In some examples, the display region 100 may be a planar region, including multiple sub-pixels Pxij that constitute a pixel array, wherein the multiple sub-pixels Pxij may be configured to display a dynamic picture or a static image, and the display region 100 may be referred to as an active region (AA). In some examples, the display substrate may be a flexible base substrate, and accordingly the display substrate may be deformed, for example, may be crimped, bent, folded, or curled.

In some exemplary embodiments, a bonding region 200 may include a fan-out zone, a bending zone, a driver chip zone, and a bonding pin zone that are sequentially disposed along a direction away from the display region 100. The fan-out zone is connected with the display region 100, and at least includes data fan-out lines. Multiple data fan-out lines are configured to connect data signal lines of the display region 100 in a fan-out trace mode. The bending zone is connected with the fan-out zone, may include a composite insulation layer provided with a groove, and is configured to bend the driver chip zone and the bonding pin zone to the back of the display region 100. An Integrated Circuit (IC) may be disposed in the driver chip zone, and the Integrated Circuit may be configured to be connected with the multiple data fan-out lines. The bonding pin zone may include a Bonding Pad, wherein the Bonding Pad may be configured to be bonded to an external Flexible Printed Circuit (FPC).

In some exemplary embodiments, the display substrate may include multiple pixel units arranged in a matrix. For example, at least one pixel unit may include a first sub-pixel emitting light of a first color, a second sub-pixel emitting light of a second color, and a third sub-pixel and a fourth sub-pixel emitting light of a third color. Each sub-pixel may include a pixel circuit and a light emitting element, wherein the pixel circuit is electrically connected with a scan signal line, a data signal line, and a light emitting control line, respectively, the pixel circuit may be configured to receive a data voltage transmitted by the data signal line and output a corresponding current to the light emitting element under controlling of the scan signal line and the light emitting control line. A light emitting element in each sub-pixel is connected with a pixel circuit of the sub-pixel where the pixel circuit is located respectively, and the light emitting element is configured to emit light of a corresponding brightness in response to a current outputted by the pixel circuit of the sub-pixel where the light emitting element is located.

In some exemplary embodiments, the first sub-pixel may be a red sub-pixel (R) emitting red light, the second sub-pixel may be a blue sub-pixel (B) emitting blue light, and the third sub-pixel and the fourth sub-pixel may be green sub-pixels (G) emitting green light. In some examples, a shape of a light emitting element of the sub-pixel may be a rectangle, a diamond, a pentagon, or a hexagon, and light emitting elements of four sub-pixels may be arranged in a Diamond mode to form an RGBG pixel arrangement. In another exemplary embodiment, light emitting elements of four sub-pixels may be arranged side by side horizontally, side by side vertically, or in a square mode, etc., which is not limited in the present disclosure. In some other exemplary embodiments, the pixel unit may include three sub-pixels, wherein light emitting elements of the three sub-pixels may be arranged side by side horizontally, side by side vertically, or in a shape of a Chinese character "品", etc., which is not limited in the present disclosure.

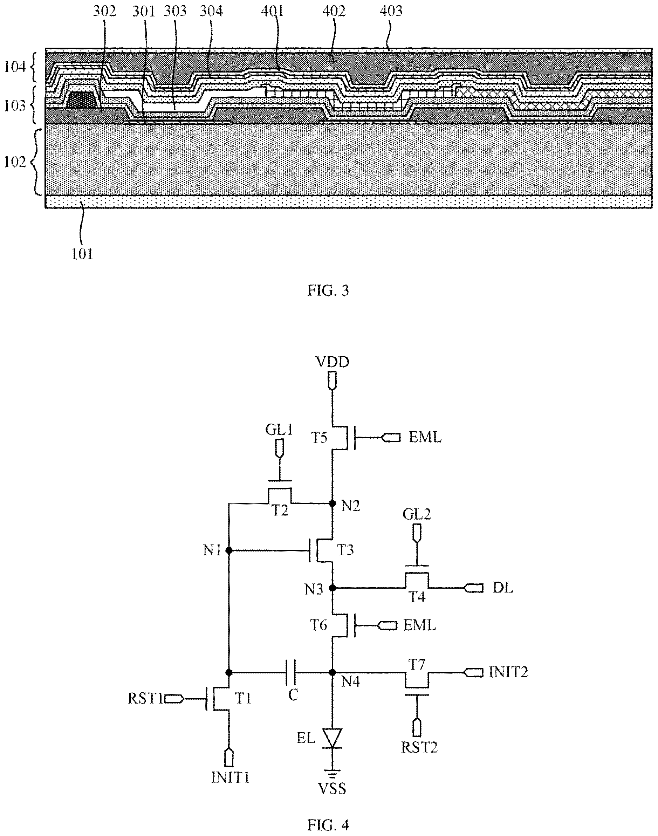

FIG. 3 is a schematic diagram of a cross-sectional structure of a display region of a display substrate. FIG. 3 illustrates a structure of three sub-pixels in the display region 100. As shown in FIG. 3, in a direction perpendicular to the display substrate, the display substrate may include: a base substrate 101, and a drive circuit layer 102, a light emitting structure layer 103, and an encapsulating structure layer 104 which are sequentially disposed on the base substrate 101. In some possible implementations, the display substrate may include other film layers, such as a touch structure layer, which is not limited here in the present disclosure.

In some exemplary embodiments, the base substrate 101 may be a flexible base substrate or a rigid base substrate. The drive circuit layer 102 of each sub-pixel may include a pixel circuit composed of multiple transistors and a capacitor. The light emitting structure layer 103 of each sub-pixel may at least include an anode 301, a pixel define layer 302, an organic emitting layer 303, and a cathode 304, wherein the anode 301 is connected with the pixel circuit, the organic emitting layer 303 is connected with the anode 301, the cathode 304 is connected with the organic emitting layer 303, and the organic light emitting layer 303 emits light of a corresponding color under driving of the anode 301 and the cathode 304. The encapsulating structure layer 104 may include a first encapsulating layer 401, a second encapsulating layer 402, and a third encapsulating layer 403 that are stacked, wherein the first encapsulating layer 401 and the third encapsulating layer 403 may be made of an inorganic material, the second encapsulating layer 402 may be made of an organic material, and the second encapsulating layer 402 is disposed between the first encapsulating layer 401 and the third encapsulating layer 403 to form an inorganic material/organic material/inorganic material laminated structure, which can ensure that external water vapor cannot enter the light emitting structure layer 103.

In some exemplary embodiments, the organic light emitting layer 303 may include a light emitting layer (EML), and any one or more of following layers: a hole injection layer (HIL), a hole transport layer (HTL), an electron block layer (EBL), a hole block layer (HBL), an electron transport layer (ETL), and an electron injection layer (EIL). In some examples, one or more of hole injection layers, hole transport layers, electron block layers, hole block layers, electron transport layers, and electron injection layers of all sub-pixels may be a common layer connected together. Light emitting layers of adjacent sub-pixels may be overlapped slightly, or may be mutually isolated.

With a gradual maturity of an OLED display technology and a continuous improvement of a yield, a cost of OLED is continuously decreasing, which makes that the OLED may be applied in more fields, such as a field of large and medium-sized electronic products. With an increase of a size of the display substrate, the yield of the display substrate using Low Temperature Poly-Silicon (LTPS) thin film transistors decreases, which leads to a high cost. Therefore, display substrates entirely using Oxide thin film transistors have been studied.

An embodiment of the present disclosure provides a display substrate, including: a base substrate and a drive circuit layer disposed on the base substrate. The drive circuit layer includes at least one pixel circuit, wherein the at least one pixel circuit includes at least one oxide thin film transistor and a capacitor. The capacitor includes a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate. In a direction perpendicular to the display substrate, a distance between the inorganic insulation layer and an active layer of the oxide thin film transistor is greater than or equal to 3000 angstroms.

In the present disclosure, the distance between the inorganic insulation layer and the active layer of the oxide thin film transistor may be: a vertical distance between a surface of a side of the inorganic insulation layer close to the active layer of the oxide thin film transistor and a surface of a side of the active layer close to the inorganic insulation layer.

In the display substrate according to the embodiment, by increasing a distance between the inorganic insulation layer disposed between two capacitor plates of the capacitor and the active layer of the oxide thin film transistor, an influence of the inorganic insulation layer on characteristics of the oxide thin film transistor can be effectively isolated, thereby improving a characteristic stability of the oxide thin film transistor of the display substrate.

In some exemplary embodiments, a material of the active layer of the oxide thin film transistor includes an indium gallium zinc oxide material (IGZO). However, the embodiment is not limited thereto. For example, the active layer of the oxide thin film transistor may be made of another metal oxide material.

In some exemplary embodiments, a material of the inorganic insulation layer between the first capacitor plate and the second capacitor plate may include a silicon nitride (SiNx). By using silicon nitride, a capacitor performance can be ensured. Moreover, by increasing a distance between the silicon nitride and the active layer of the oxide thin film transistor, an influence of a hydrogen (H) element in the inorganic insulation layer on the characteristics of the oxide thin film transistor can be eliminated, and the characteristic stability of oxide thin film transistor can be improved.

In some exemplary embodiments, the pixel circuit may include a drive transistor, the first capacitor plate of the capacitor and a gate of the drive transistor are equipotential, and the second capacitor plate of the capacitor is electrically connected with an anode of a light emitting element. Herein, the first capacitor plate of the capacitor may be electrically connected with the gate of the drive transistor.

In some exemplary embodiments, the drive circuit layer may at least include: a first conductive layer, a second conductive layer, and a semiconductor layer that are sequentially disposed on the base substrate. The semiconductor layer may include: an active layer of at least one oxide thin film transistor, the first conductive layer at least includes the first capacitor plate of the capacitor, and the second conductive layer at least includes the second capacitor plate of the capacitor. In some examples, a third insulation layer is disposed between the second conductive layer and the semiconductor layer, wherein a material of the third insulation layer may include a silicon oxide. In some examples, a thickness of the third insulation layer may be about 3500 angstroms to 4500 angstroms. For example, the thickness of the third insulation layer may be about 4000 angstroms. In this example, the third insulation layer can be used to block an upward penetration of a hydrogen element in the inorganic insulation layer, which avoids an influence of the hydrogen element on the characteristics of the oxide thin film transistor.

In some exemplary embodiments, the drive circuit layer may include: a semiconductor layer, a second conductive layer, a fourth conductive layer, and a fifth conductive layer that are sequentially disposed on the base substrate. The semiconductor layer includes an active layer of at least one oxide thin film transistor, the second conductive layer includes a gate of at least one oxide thin film transistor, the fourth conductive layer at least includes the first capacitor plate of the capacitor, and the fifth conductive layer at least includes the second capacitor plate of the capacitor. In some examples, a fifth insulation layer is disposed between the fourth conductive layer and the second conductive layer, wherein a material of the fifth insulation layer includes a silicon oxide, and a thickness of the fifth insulation layer is substantially 4500 angstroms to 5500 angstroms. For example, the thickness of the fifth insulation layer may be about 5000 angstroms. In this example, the fifth insulation layer can be used to block a downward penetration of a hydrogen element in the inorganic insulation layer, which avoids an influence of the hydrogen element on the characteristics of the oxide thin film transistor.

The display substrate of the embodiment will now be described with some examples.

FIG. 4 is an equivalent circuit diagram of a pixel circuit according to at least one embodiment of the present disclosure. In some examples, the pixel circuit may be in a structure of 3T1C, 4T1C, 5T1C, 5T2C, 6T1C, 7T1C, or 8T1C. The pixel circuit of the exemplary embodiment is described by taking the structure of 7T1C as an example. However, the embodiment is not limited thereto.

In some examples, as shown in FIG. 4, the pixel circuit of this example may include seven transistors (i.e. a first transistor T1 to a seventh transistor T7) and one capacitor C. The pixel circuit is respectively connected with ten signal lines (including, for example, a data signal line DL, a first scan signal line GL1, a second scan signal line GL2, a third scan signal line RST1, a fourth scan signal line RST2, a light emitting control line EML, a first initial signal line INIT1, a second initial signal line INIT2, a first power supply line VDD and a second power supply line VSS).

In some examples, seven transistors in the pixel circuit may be N-type transistors. Adopting a same type of transistors in a pixel circuit may simplify a process flow, reduce a process difficulty of a display substrate, and improve a yield of products.

In some examples, seven transistors in the pixel circuit may be oxide thin film transistors. The active layer of the oxide thin film transistor may be made of an oxide semiconductor (Oxide). The oxide thin film transistor has advantages of a low leakage current and so on. Using the display substrate equipped with the oxide thin film transistor may achieve low frequency driving, reduce a power consumption, and improve a display quality.

In some examples, the first power supply line VDD may be configured to supply a constant first voltage signal to the pixel circuit, the second power supply line VSS may be configured to supply a constant second voltage signal to the pixel circuit, and the first voltage signal is greater than the second voltage signal. The first scan signal line GL1 may be configured to supply a first scan signal SCAN1 to the pixel circuit, the second scan signal line GL2 may be configured to supply a second scan signal SCAN2 to the pixel circuit, the data signal line DL may be configured to supply a data signal DATA to the pixel circuit, and the light emitting control line EML may be configured to supply a light emitting control signal EM to the pixel circuit. The third scan signal line RST1 may be configured to supply a third scan signal Reset1 to the pixel circuit, and the fourth scan signal line RST2 may be configured to supply a fourth scan signal Reset2 to the pixel circuit. In some examples, in an n-th row of pixel circuits, the third scan signal line RST1 may be electrically connected with the first scan signal line GL1 of an (n-1)-th row of pixel circuits to be inputted with the first scan signal SCAN1 (n-1). The fourth scan signal line RST2 of the n-th row of pixel circuits may be electrically connected with the first scan signal line GL1 of the n-th row of pixel circuits to be inputted with the first scan signal SCAN1(n). In some examples, the fourth scan signal line RST2 electrically connected to the n-th row of pixel circuits and the third scan signal line RST1 electrically connected to the (n+1)-th row of pixel circuits may be in an integral structure. Herein, n is an integer greater than 0. Thus, signal lines of the display substrate may be reduced, achieving a design of a narrow frame of the display substrate. However, the embodiment is not limited thereto.

In some examples, the first initial signal line INIT1 may be configured to supply a first initial signal to the pixel circuit, and the second initial signal line INIT2 may be configured to supply a second initial signal to the pixel circuit. For example, the first initial signal may be different from the second initial signal. The first initial signal and the second initial signal may be constant voltage signals, a size of which may be, for example, between the first voltage signal supplied by the first power supply line VDD and the second voltage signal supplied by the second power supply line VSS, but not limited to this. In some other examples, the first initial signal and the second initial signal may be the same, and only the first initial signal line may be disposed to supply the first initial signal.

In some examples, as shown in FIG. 4, a gate of the first transistor T1 is electrically connected with the third scan signal line RST1, a first electrode of the first transistor T1 is electrically connected with the first initial signal line INIT1, and a second electrode of the first transistor T1 is electrically connected with a gate of the third transistor T3. A gate of the second transistor T2 is electrically connected with the first scan signal line GL1, a first electrode of the second transistor T2 is electrically connected with the gate of the third transistor T3, and a second electrode of the second transistor T2 is electrically connected with a first electrode of the third transistor T3. The gate of the third transistor T3 is electrically connected with a first node N1, the first electrode of the third transistor T3 is electrically connected with a second node N2, and the second electrode of the third transistor T3 is electrically connected with a third node N3. The third transistor T3 may be referred to as a drive transistor, and the third transistor T3 determines an amount of a drive current flowing between the first power supply line VDD and the second power supply line VSS according to a potential difference between the gate and the second electrode of the third transistor T3. A gate of the fourth transistor T4 is electrically connected with the second scan signal line GL2, a first electrode of the fourth transistor T4 is electrically connected with the data signal line DL, and a second electrode of the fourth transistor T4 is electrically connected with the second electrode of the third transistor T3. A gate of the fifth transistor T5 is electrically connected with the light emitting control line EML, a first electrode of the fifth transistor T5 is electrically connected with the first power supply line VDD, and a second electrode of the fifth transistor T5 is electrically connected with the first electrode of the third transistor T3. A gate of the sixth transistor T6 is electrically connected with the light emitting control line EML, a first electrode of the sixth transistor T6 is electrically connected with a second electrode of the third transistor T3, and a second electrode of the sixth transistor T6 is electrically connected with an anode of the light emitting element EL. The fifth transistor T5 and the sixth transistor T6 may be referred to as light emitting transistors. A gate of the seventh transistor T7 is electrically connected with the fourth scan signal line RST2, a first electrode of the seventh transistor T7 is electrically connected with the second initial signal line INIT2, and a second electrode of the seventh transistor T7 is electrically connected with the anode of the light emitting element EL. The first capacitor plate of the capacitor C is electrically connected with the gate of the third transistor T3, and the second capacitor plate of the capacitor is electrically connected with the anode of the light emitting element EL.

In this example, the first node N1 is a connecting point for the capacitor C, the first transistor T1, the third transistor T3, and the second transistor T2, the second node N2 is a connecting point for the second transistor T2, the fifth transistor T5, and the third transistor T3, the third node N3 is a connecting point for the third transistor T3, the fourth transistor T4, and the sixth transistor T6, and the fourth node N4 is a connecting point for the sixth transistor T6, the seventh transistor T7, the capacitor C, and the light emitting element EL.

In some examples, the light emitting element EL may be an OLED, including a first electrode (an anode), an organic light emitting layer, and a second electrode (a cathode) that are stacked, or may be a QLED, including a first electrode (an anode), a quantum dot light emitting layer, and a second electrode (a cathode) that are stacked. The second electrode of the light emitting element is connected with the second power supply line VSS, a signal of the second power supply line VSS is a low-level signal continuously supplied, and a signal of the first power supply line VDD is a high-level signal continuously supplied.

In some examples, taking the first transistor T1 to the seventh transistor T7 included in the pixel circuit being all N-type transistors as an example, an operating process of the pixel circuit may include the following stages A1 to A3.

The first stage A1 is referred to as an initialization stage. A high-level signal supplied by the third scan signal line RST1 makes the first transistor T1 be turned on, and the first initial signal supplied by the first initial signal line INIT1 is supplied to the first node N1 to initialize the first node N1, clearing an original data voltage in the capacitor C. The first scan signal line GL1, the second scan signal line GL2, the fourth scan signal line RST2, and the light emitting control line EML supply low-level signals to make the second transistor T2, the fourth transistor T4, the fifth transistor T5, the sixth transistor T6, and the seventh transistor T7 be turned off. In this stage, the light emitting element EL does not emit light.

The second stage A2 is referred to as a data writing stage or a threshold compensation stage. The first scan signal line GL1 supplies a high-level signal, the second scan signal line GL2 supplies a high-level signal, and the data signal line DL outputs a data signal DATA. The second transistor T2 is turned on, potentials of the gate and the first electrode of the third transistor T3 are the same, and the third transistor T3 is in a diode-connected state, so the third transistor T3 is turned on. The first scan signal line GL1 supplies a high-level signal to make the second transistor T2 be turned on, the first scan signal line GL2 supplies a high-level signal to make the fourth transistor T4 be turned on, and the fourth scan signal line RST2 supplies a high-level signal to make the seventh transistor T7 be turned on. The second transistor T2 and the fourth transistor T4 are turned on, so that a data voltage Vdata outputted from the data signal line DL is supplied to the first node N1 through the third node N3, the turned-on third transistor T3, the second node N2, and the turned-on second transistor T2, and a difference between the data voltage Vdata outputted from the data signal line DL and a threshold voltage Vth of the third transistor T3 is charged into the capacitor. The seventh transistor T7 is turned on, so that the second initial signal supplied by the second initial signal line INIT2 is supplied to the anode of the light emitting element EL to initialize (reset) the anode of the light emitting element EL, clearing a pre-stored voltage therein, so as to complete initialization, thereby ensuring that the light emitting element EL does not emit light. The third scan signal line RST1 supplies a low-level signal to make the first transistor T1 be turned off. The light emitting control line EML supplies a low-level signal to make the fifth transistor T5 and the sixth transistor T6 be turned off.

The third stage A3 is referred to as a light emitting stage. The light emitting control line EML supplies a high-level signal, and the first scan signal line GL1, the second scan signal line GL2, the third scan signal line RST1, and the fourth scan signal line RST2 all provide a low-level signal. The light emitting control line EML supplies a high-level signal to make the fifth transistor T5 and the sixth transistor T6 be turned on, and a first voltage signal outputted from the first power supply line VDD supplies a drive voltage to the anode of the light emitting element EL through the fifth transistor T5, the third transistor T3, and the sixth transistor T6 that are turned on to drive the light emitting element EL to emit light.

In a drive process of a pixel drive circuit, a drive current flowing through the third transistor T3 (i.e., a drive transistor) is determined by a voltage difference between the gate electrode and the second electrode of the third transistor T3. Because the voltage of the first node N1 is Vdata-Vth, the driving current of the third transistor T3 is:

$$ I = K \times (Vgs-Vth)^2 = K \times [(Vdd-Vdata+|Vth|)-Vth]^2 = K \times [Vdd-Vdata]^2. $$

Herein, I is the drive current flowing through the third transistor T3, i.e., a drive current for driving the light emitting element EL, K is a constant, Vgs is the voltage difference between the gate and the second electrode of the third transistor T3, Vth is the threshold voltage of the third transistor T3, Vdata is the data voltage outputted by the data signal line DL, and Vdd is the first voltage signal outputted from the first power supply line VDD.

It may be seen from the above formula that a current flowing through the light emitting element EL is independent of the threshold voltage of the third transistor T3. The pixel circuit of the embodiment may better compensate the threshold voltage of the third transistor T3.

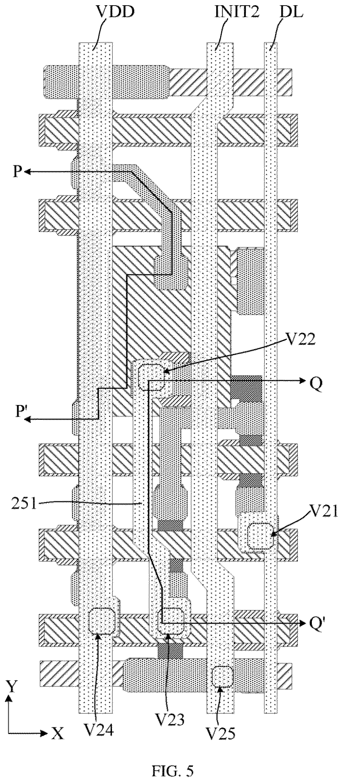

FIG. 5 is a schematic partial top diagram of a drive circuit layer according to at least one embodiment of the present disclosure. In FIG. 5, an illustration is made by taking one pixel circuit of the drive circuit layer as an example.

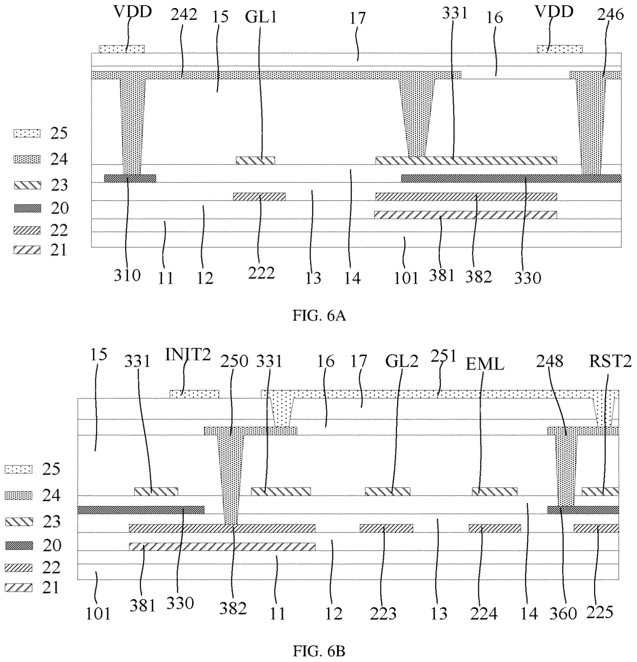

FIG. 6A is a partial sectional view along a P-P' direction in FIG. 5. FIG. 6B is a partial sectional view along a Q-Q' direction in FIG. 5.

In some examples, as shown in FIGs. 6A and 6B, in a direction perpendicular to the display substrate, the drive circuit layer may include: a first conductive layer 21, a second conductive layer 22, a semiconductor layer 20, a third conductive layer 23, a fourth conductive layer 24, and a fifth conductive layer 25 that are sequentially disposed on the base substrate 101. In some examples, the first conductive layer 21 at least may include: a first capacitor plate 381 of the capacitor, and the second conductive layer 22 at least may include: a second capacitor plate 382 of the capacitor. Herein, the first conductive layer 21 may also be referred to as a Light Shielding (LS) layer, the second conductive layer 22 may also be referred to as a first gate metal (Gate1) layer, the third conductive layer 23 may also be referred to as a second gate metal (Gate2) layer, the fourth conductive layer 24 may also be referred to as a first source-drain metal (SD1) layer, and the fifth conductive layer 25 may also be referred to as a second source-drain metal (SD2) layer.

In some examples, as shown in FIGs. 6A and 6B, the drive circuit layer may further at least include: a first insulation layer 11, a second insulation layer 12, a third insulation layer 13, a fourth insulation layer 14, a fifth insulation layer 15, a sixth insulation layer 16, and a seventh insulation layer 17. The first insulation layer 11 may be disposed between the base substrate 101 and the first conductive layer 21, and the first insulation layer 11 may also be referred to as a Barrier layer. The second insulation layer 12 may be disposed between the first conductive layer 21 and the second conductive layer 22, and the second insulation layer 12 may also be referred to as a first gate insulation (GI1) layer. In this example, the second insulation layer 12 is the aforementioned inorganic insulation layer. The third insulation layer 13 may be disposed between the second conductive layer 22 and the semiconductor layer 20, and the third insulation layer 13 and may also be referred to as a Buffer layer. The fourth insulation layer 14 may be disposed between the semiconductor layer 20 and the third conductive layer 23, and the fourth insulation layer 14 may also be referred to as a second gate insulation (GI2) layer. The fifth insulation layer 15 may be disposed between the third conductive layer 23 and the fourth conductive layer 24, and the fifth insulation layer 15 may also be referred to as an interlayer insulation (ILD) layer. The sixth insulation layer 16 and the seventh insulation layer 17 may be disposed between the fourth conductive layer 24 and the fifth conductive layer 25, and the sixth insulation layer 16 may be located at a side of the seventh insulation layer 17 close to the base substrate 101. The sixth insulation layer 16 may also be referred to as a passivation (PVX) layer, and the seventh insulation layer 17 may also be referred to as a flat (PLN) layer. In some examples, a material of the first insulation layer 11 to the sixth insulation layer 16 may be an inorganic material, and a material of the seventh insulation layer 17 may be an organic material. However, the embodiment is not limited thereto. In some other examples, only the seventh insulation layer may be disposed between the fourth conductive layer and the fifth conductive layer.

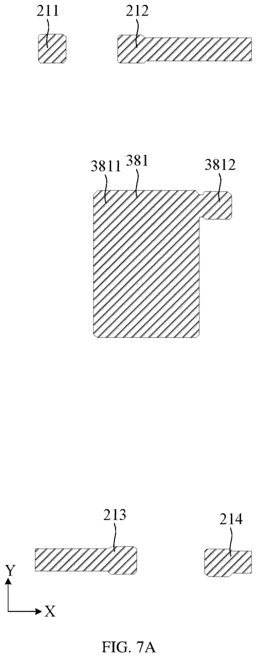

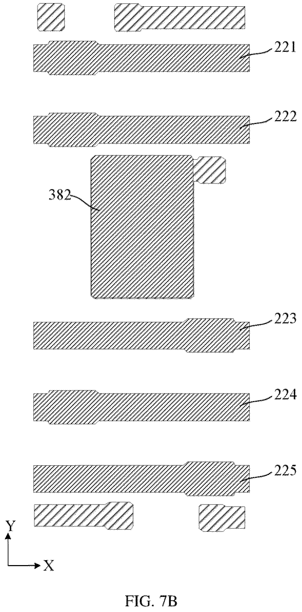

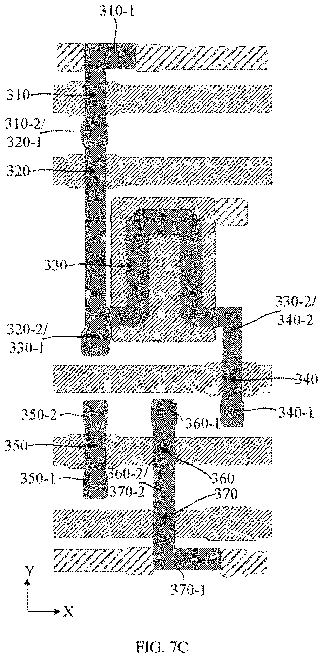

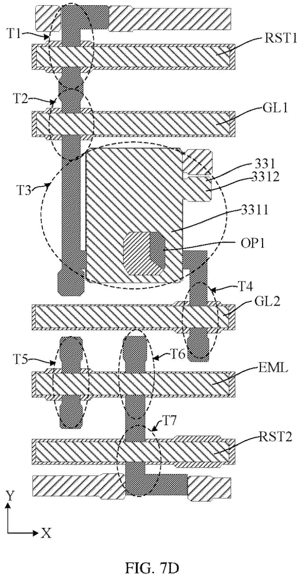

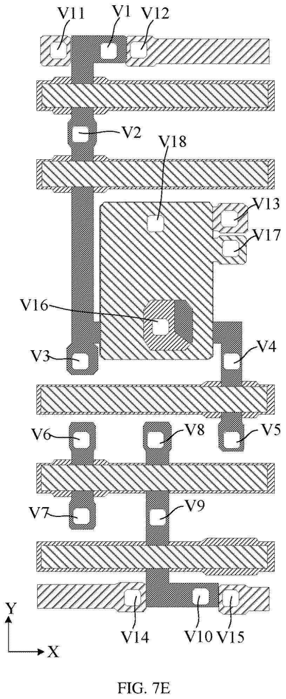

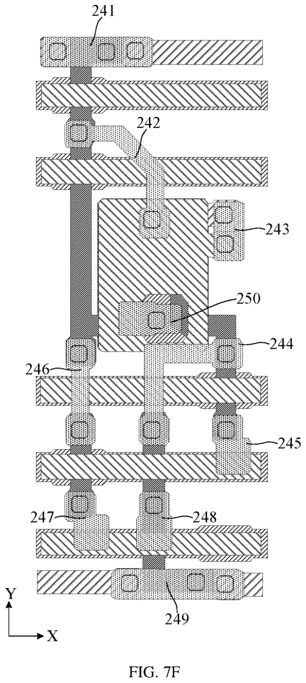

An exemplary description will be given for a structure and a preparing process of the display substrate below with reference to FIGs. 5 to 7F. Herein, FIG. 7A is a partially enlarged schematic diagram of a drive circuit layer after a first conductive layer is formed in FIG. 5. FIG. 7B is a partially enlarged schematic diagram of a drive circuit layer after a second conductive layer is formed in FIG. 5. FIG. 7C is a partially enlarged schematic diagram of a drive circuit layer after a semiconductor layer is formed in FIG. 5. FIG. 7D is a partially enlarged schematic diagram of a drive circuit layer after a third conductive layer is formed in FIG. 5. FIG. 7E is a partially enlarged schematic diagram of a drive circuit layer after a fifth insulation layer is formed in FIG. 5. FIG. 7F is a partially enlarged schematic diagram of a drive circuit layer after a fourth conductive layer is formed in FIG. 5.

The "patterning process" mentioned in the embodiments of the present disclosure includes processes, such as photoresist coating, mask exposure, development, etching and photoresist stripping for metal materials, inorganic materials or transparent conductive materials, and includes organic material coating, mask exposure and development for organic materials. Deposition may be any one or more of sputtering, evaporation, and chemical vapor deposition. Coating may be any one or more of spray coating, spin coating, and ink-jet printing. Etching may be any one or more of dry etching and wet etching, which is not limited in present disclosure. A "thin film" refers to a layer of thin film formed by a material on a base substrate through deposition, coating, or other processes. If the "thin film" does not need a patterning process in an entire manufacturing process, the "thin film" may also be called a "layer". If the "thin film" needs a patterning process in an entire manufacturing process, it is called a "thin film" before the patterning process, and called a "layer" after the patterning process. The "layer" after the patterning process includes at least one "pattern".

In some exemplary implementation modes, a preparation process of a display substrate may include following operations. A circuit structure of the pixel circuit of the drive circuit layer may be shown in FIG. 4. Herein, the first transistor T1 to the seventh transistor T7 of the pixel circuit may all be oxide thin film transistors.

(1-1) The base substrate is provided.

In some examples, the base substrate 101 may be a rigid base substrate, or may be a flexible base substrate. For example, the rigid base substrate may be made of, but not limited to, one or more of glass and quartz, and the flexible base substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some exemplary embodiments, the flexible base substrate may include a first flexible material layer, a first inorganic material layer, a semiconductor layer, a second flexible material layer, and a second inorganic material layer that are stacked, wherein materials of the first flexible material layer and the second flexible material layer may be a material such as polyimide (PI), polyethylene terephthalate (PET), or a surface-treated polymer soft film, etc., materials of the first inorganic material layer and the second inorganic material layer may be a silicon nitride (SiNx) or a silicon oxide (SiOx), etc., for improving a capability of water-resistance of the base substrate, and a material of the semiconductor layer may be amorphous silicon (a-si).

(1-2) The first conductive layer is formed.

In some examples, a first insulation thin film and a first conductive thin film are sequentially deposited on the base substrate 101, and the first conductive thin film is patterned by a patterning process to form the first insulation layer 11 and the first conductive layer 21 disposed on the base substrate 101. As shown in FIG. 7A, the first conductive layer 21 may at least include: a first capacitor plate 381 of the capacitor. The first capacitor plate 381 may include: a first body 3811 and a first bump 3812 projecting from a side of the first body 3811 along a first direction X. An orthographic projection of the first body 3811 on the base substrate 101 may be rectangle, for example may be a rounded rectangle. An orthographic projection of the first bump 3812 on the base substrate 101 may be a rectangle, for example may be a rounded rectangle. In this example, the first capacitor plate 381 may also be reused as a light shielding electrode of an active layer of the drive transistor.

In some examples, as shown in FIG. 7A, the first conductive layer 21 may also include: a first connecting trace 211, a second connecting trace 212, a third connecting trace 213, and a fourth connecting trace 214. The first connecting trace 211, the second connecting trace 212, the third connecting trace 213, and the fourth connecting trace 214 may all extend along the first direction X. The first connecting trace 211 and the second connecting trace 212 are aligned in the first direction X, and are located at a side of the first capacitor plate 381 in a second direction Y. The third connecting trace 213 and the fourth connecting trace 214 are aligned in the first direction X, and are located at another side of the first capacitor plate 381 in the second direction Y. The first direction X intersects with the second direction Y, for example, the first direction X may be perpendicular to the second direction Y. The first connecting trace 211 and the second connecting trace 212 may subsequently be electrically connected and configured to transmit the first initial signal. The third connecting trace 213 and the fourth connecting trace 214 may subsequently be electrically connected and configured to transmit the second initial signal.

(1-3) The second conductive layer is formed.

In some examples, a second insulation thin film and a second conductive thin film are sequentially deposited on the base substrate 101 on which the aforementioned pattern is formed, and the second conductive thin film is patterned through a patterning process to form a second insulation layer 12 covering the first conductive layer 21 and a second conductive layer 22 disposed on the second insulation layer 12. As shown in FIG. 7B, the second conductive layer 22 may at least include: a second capacitor plate 382 of the capacitor. An orthographic projection of the second capacitor plate 382 on the base substrate 101 may be a rectangle, for example, may be a rounded rectangle. An orthographic projection of the first body 3811 of the first capacitor plate 381 on the base substrate 101 and an orthographic projection of the second capacitor plate 382 on the base substrate 101 may be overlapped. For example, an orthographic projection of the second capacitor plate 382 on the base substrate 101 and an orthographic projection of the first body 3811 of the first capacitor plate 381 on the base substrate 101 may coincide, or, an orthographic projection of the second capacitor plate 382 on the base substrate 101 may be located within a range of the orthographic projection of the first body 3811 of the first capacitor plate 381 on the base substrate 101, or an orthographic projection of the second capacitor plate 382 on the base substrate 101 may cover the orthographic projection of the first body 3811 of the first capacitor plate 381 on the base substrate 101. The embodiment is not limited thereto.

In some examples, as shown in FIG. 7B, the second conductive layer 22 may also at least include: a first trace 221, a second trace 222, a third trace 223, a fourth trace 224, and a fifth trace 225. The first trace 221, the second trace 222, the third trace 223, the fourth trace 224, and the fifth trace 225 may all extend along the first direction X, and may be configured to shield a channel region of the active layer of the oxide thin film transistor. The first trace 221 and the second trace 222 may be located at a side of the second capacitor plate 382 in the second direction Y, and the third trace 223 to the fifth trace 225 may be located at another side of the second capacitor plate 382 in the second direction Y. However, the embodiment is not limited thereto. In some other examples, the first trace 221 to the fifth trace 225 may be disposed on the first conductive layer 21.

(1-4) The semiconductor layer is formed.

In some examples, a third insulation thin film and a semiconductor thin film are sequentially deposited on the base substrate 101 on which the aforementioned patterns are formed, and the semiconductor thin film is patterned through a patterning process to form the third insulation layer 13 and the semiconductor layer 20 disposed on the base substrate 101. As shown in FIG. 7C, the semiconductor layer 20 may at least include: a first active layer 310 of the first transistor T1 to a seventh active layer 370 of the seventh transistor T7. The first active layer 310 of the first transistor T1 to the fourth active layer 340 of the fourth transistor T4 may be an integral structure connected to each other. The sixth active layer 360 of the sixth transistor T6 and the seventh active layer 370 of the seventh transistor T7 may be an integral structure. The fifth active layer 350 of the fifth transistor T5 may be located at a side of the sixth active layer 360 away from the fourth active layer 340 in the second direction Y.

In some examples, as shown in FIG. 7C, a shape of the first active layer 310 may be L-shaped, a shape of the third active layer 330 may be n-shaped, shapes of the second active layer 320, the fourth active layer 340, the fifth active layer 350, and the sixth active layer 360 may be strip-shaped extending along the second direction Y, and a shape of the seventh active layer 370 may be L-shaped. However, the embodiment is not limited thereto.

In some examples, an active layer of each transistor may include: a first region, a second region, and a channel region located between the first region and the second region. In some examples, as shown in FIG. 7C, a first region 310-1 of the first active layer 310, a first region 350-1 and a second region 250-2 of the fifth active layer 350, a first region 340-1 of the fourth active layer 340, a first region 360-1 of the sixth active layer 360, and a first region 370-1 of the seventh active layer 370 may be individually disposed. A second region 310-2 of the first active layer 310 may simultaneously serve as a first region 320-1 of the second active layer 320, a second region 320-2 of the second active layer 320 may simultaneously serve as a first region 330-1 of the third active layer 330, a second region 330-2 of the third active layer 330 may simultaneously serve as a second region 340-2 of the fourth active layer 340, and a second region 360-2 of the sixth active layer 360 may simultaneously serve as a second region 370-2 of the seventh active layer 370.

(1-5) The third conductive layer is formed.

In some examples, a fourth insulation thin film and a third conductive thin film are sequentially deposited on the base substrate 101 on which the aforementioned patterns are formed, and the third conductive thin film is patterned through a patterning process to form the fourth insulation layer 14 and the third conductive layer 23 disposed on the base substrate 101. As shown in FIG. 7D, the third conductive layer 23 may at least include: a first scan signal line GL1, a second scan signal line GL2, a third scan signal line RST1, a fourth scan signal line RST2, a light emitting control line EML, and a gate 331 of the third transistor T3. The first scan signal line GL1 to the fourth scan signal line RST2 and the light emitting control line EML may all extend along the first direction X.

In some examples, as shown in FIG. 7D, the gate 331 of the third transistor T3 may include: a second body 3311 and a second bump 3312 projecting from the second body 3311 along the first direction X. An orthographic projection of the second body 3311 on the base substrate 101 may be a rectangle, for example may be a rounded rectangle. An orthographic projection of the second bump 3312 on the base substrate 101 may be a rectangle, for example may be a rounded rectangle. The second body 3311 may have a hollow region OP1. An orthographic projection of the hollow region OP1 on the base substrate 101 may be located within a range of the orthographic projection of the second capacitor plate 382 on the base substrate 101. The orthographic projection of the second body 3311 on the base substrate 101 may be overlapped with the orthographic projection of the second capacitor plate 382 on the base substrate 101. For example, the orthographic projection of the second body 3311 on the base substrate 101 may be located within the range of the orthographic projection of the second capacitor plate 382 on the base substrate 101, or the orthographic projection of the second capacitor plate 382 on the base substrate 101 may be located within a range of the orthographic projection of the second body 3311 on the base substrate 101. The second bump 3312 of the gate 331 of the third transistor T3 and the first bump 3812 of the first capacitor plate 381 may be located at a same side of the second body 3311 in the first direction X. The orthographic projection of the second bump 3312 on the base substrate 101 and the orthographic projection of the first bump 3812 of the first capacitor plate 381 on the base substrate 101 may not be overlapped.

In some examples, as shown in FIGs. 7A to 7D, orthographic projections of the first capacitor plate 381 and the second capacitor plate 382 of the capacitor on the base substrate 101 may both be overlapped with an orthographic projection of a channel region of an active layer 310 of the third transistor T3 on the base substrate 101. The channel region of the active layer 310 of the third transistor T3 may be an overlapping region of the active layer 310 and the gate 331.

In some examples, as shown in FIG. 7D, an orthographic projection of the first scan signal line GL1 on the base substrate 101 may be located between orthographic projections of the third scan signal line RST1 and the gate 331 of the third transistor T3 on the base substrate 101, an orthographic projection of the second scan signal line GL2 on the base substrate 101 may be located between orthographic projections of the light emitting control line EML and the gate 331 of the third transistor T3 on the base substrate 101, and an orthographic projection of the fourth scan signal line RST2 on the base substrate 101 may be located at a side of the light emitting control line EML away from the second scan signal line GL2.

In some examples, as shown in FIGs. 7B and 7D, an orthographic projection of the third scan signal line RST1 on the base substrate 101 may be located within a range of an orthographic projection of the first trace 221 on the base substrate 101, the orthographic projection of the first scan signal line GL1 on the base substrate 101 may be located within a range of an orthographic projection of the second trace 222 on the base substrate 101, the orthographic projection of the second scan signal line GL2 on the base substrate 101 may be located within a range of an orthographic projection of the third trace 223 on the base substrate 101, an orthographic projection of the light emitting control line EML on the base substrate 101 may be located within a range of an orthographic projection of the fourth trace 224 on the base substrate 101, and an orthographic projection of the fourth scan signal line RST2 on the base substrate 101 may be located within a range of an orthographic projection of the fifth trace 225 on the base substrate 101.

In some examples, as shown in FIG. 7D, an overlapping region of the third scan signal line RST1 and the first active layer 310 may serve as a gate of the first transistor T1, an overlapping region of the first scan signal line GL1 and the second active layer 320 may serve as a gate of the second transistor T2, an overlapping region of the second scan signal line GL2 and the fourth active layer 340 may serve as a gate of the fourth transistor T4, an overlapping region of the light emitting control line EML and the fifth active layer 350 may serve as a gate of the fifth transistor T5, an overlapping region of the light emitting control line EML and the sixth active layer 360 may serve as a gate of the sixth transistor T6, and an overlapping region of the fourth scan signal line RST2 and the seventh active layer 370 may serve as a gate of the seventh transistor T7.

In some examples, as shown in FIGs. 7C and 7D, an overlapping region of the first trace 221 and the first active layer 310 may serve as a bottom gate of the first transistor T1, an overlapping region of the second trace 222 and the second active layer 320 may serve as a bottom gate of the second transistor T2, an overlapping region of the third trace 223 and the fourth active layer 340 may serve as a bottom gate of the fourth transistor T4, an overlapping region of the fourth trace 224 and the fifth active layer 350 may serve as a bottom gate of the fifth transistor T5, an overlapping region of the fourth trace 224 and the sixth active layer 360 may serve as the bottom gate of the sixth transistor T6, and an overlapping region of the fifth trace 225 and the seventh active layer 370 may serve as a bottom gate of the seventh active layer T7. An overlapping region of the second capacitor plate 382 of the capacitor and the third active layer 330 may serve as a bottom gate of the third transistor T3.

(1-6) The fifth insulation layer is formed.

In some examples, a fifth insulation thin film is deposited on the base substrate 101 on which the aforementioned patterns are formed, and the fifth insulation thin film is patterned through a patterning process to form the fifth insulation layer 15 disposed on the base substrate 101. As shown in FIG. 7E, the fifth insulation layer 15 is provided with multiple vias, which may include, for example, a first via V1 to an eighteenth via V18. The fifth insulation layer 15 and the fourth insulation layer 14 within the first via V1 to the tenth via V10 are removed to expose a surface of the semiconductor layer 20. The fifth insulation layer 15, the fourth insulation layer 14, the third insulation layer 13, and the second insulation layer 12 within the eleventh via V11 to the fifteenth via V15 are removed to expose a surface of the first conductive layer 21. The fifth insulation layer 15, the fourth insulation layer 14, and the third insulation layer 13 within the sixteenth via V16 are removed to expose a surface of the second conductive layer 22. An orthographic projection of the sixteenth via V16 on the base substrate may be located within a range of an orthographic projection of the hollow region OP1 of the gate 331 of the third transistor T3 on the base substrate. The fifth insulation layer 15 within the seventeenth via V17 and the eighteenth via V18 is removed to expose a surface of the third conductive layer 23.

(1-7) The fourth conductive layer is formed.

In some examples, a fourth conductive thin film is deposited on the base substrate 101 on which the aforementioned patterns are formed, and the fourth conductive thin film is patterned through a patterning process to form the fourth conductive layer 24 disposed on the base substrate 101. As shown in FIG. 7F, the fourth conductive layer 24 may at least include: multiple connecting electrodes (e.g. a first connecting electrode 241 to a tenth connecting electrode 250).

In some examples, as shown in FIGs. 7E and 7F, the first connecting electrode 241 may be electrically connected with the first region 310-1 of the first active layer 310 through the first via V1, may also be electrically connected with the first connecting trace 211 through the eleventh via V11, and may also be electrically connected with the second connecting trace 212 through the twelfth via V12. The first connecting trace 211, the first connecting electrode 241, and the second connecting trace 212 are electrically connected, which may achieve a transmission of the first initial signal along the first direction X. The second connecting electrode 242 may be electrically connected with the second region 310-2 of the first active layer 310 through the second via V2, and may also be electrically connected with the second body 3311 of the gate 331 of the third transistor T3 through the eighteenth via V18. The third connecting electrode 243 may be electrically connected with the first bump 3812 of the first capacitor plate 381 through the thirteenth via V13, and may also be electrically connected with the second bump 3312 of the gate 331 of the third transistor T3 through the seventeenth via V17. An electrical connection of the first capacitor plate 381 of the capacitor and the gate 331 of the third transistor T3 may be achieved through the third connecting electrode 243. The fourth connecting electrode 244 may be electrically connected with the second region 340-2 of the fourth active layer 340 through the fourth via V4, and may also be electrically connected with the first region 360-1 of the sixth active layer 360 through the eighth via V8. For example, an orthographic projection of the fourth connecting electrode 244 on the base substrate may be L-shaped. The fifth connecting electrode 245 may be electrically connected with the first region 340-1 of the fourth active layer 340 through the fifth via V5. The sixth connecting electrode 246 may be electrically connected with the second region 320-2 of the second active layer 320 through the third via V3, and may also be electrically connected with the second region 350-2 of the fifth active layer 350 through the sixth via V6. The seventh connecting electrode 247 may be electrically connected with the first region 350-1 of the fifth active layer 350 through the seventh via V7. The eighth connecting electrode 248 may be electrically connected with the second region 360-2 of the sixth active layer 360 through the ninth via V9. The ninth connecting electrode 249 may be electrically connected with the first region 370-1 of the seventh active layer 370 through the tenth via V10, may also be electrically connected with the third connecting trace 213 through the fourteenth via V14, and may also be electrically connected with the fourth connecting trace 214 through the fifteenth via V15. The third connecting trace 213, the ninth connecting electrode 249, and the fourth connecting trace 214 are electrically connected, which may achieve a transmission of the second initial signal along the first direction X. The tenth connecting electrode 250 may be electrically connected with the second capacitor plate 382 of the capacitor through the sixteenth via V16.

(1-8) The fifth conductive layer is formed.

In some examples, a sixth insulation thin film is deposited on the base substrate 101 on which the aforementioned patterns are formed, and then a seventh insulation thin film is coated, and the seventh insulation thin film and the sixth insulation thin film are patterned through a patterning process to form the sixth insulation layer 16 and the seventh insulation layer 17. In some examples, the sixth insulation layer 16 may be further etched within a via or a groove of the seventh insulation layer 17 after the via or the groove is formed on the seventh insulation layer 17 to form a via or a groove located on the sixth insulation layer 16 and expose a surface of the fourth conductive layer 24. For example, as shown in FIG. 5, the seventh insulation layer 17 may be provided with a twenty-first via V21 to a twenty-fifth via V25.
In some examples, a fifth insulation thin film is deposited on the base substrate 101 on which the aforementioned patterns are formed, and the fifth insulation thin film is patterned through a patterning process to form the fifth conductive layer 25. As shown in FIG. 5, the fifth conductive layer 25 may include: an eleventh connecting electrode 251, the first power supply line VDD, the second initial signal line INIT2, and the data signal line DL. The first power supply line VDD, the second initial signal line INIT2, and the data signal line DL may all extend along the second direction Y. The second initial signal line INIT2 may be located between the first power supply line VDD and the data signal line DL in the first direction X. The eleventh connecting electrode 251 may be located between the first power supply line VDD and the second initial signal line INIT2 in the first direction X.
In some examples, as shown in FIG. 5, the eleventh connecting electrode 251 may be electrically connected with the tenth connecting electrode 250 through the twenty-second via V22, and may also be electrically connected with the eighth connecting electrode 248 through the twenty-third via V23, which achieves an electrical connection of the second capacitor plate 382 of the capacitor and the second electrode of the sixth transistor T6. The eleventh connecting electrode 251 may also subsequently be electrically connected with the anode of the light emitting element. The first power supply line VDD may be electrically connected with the seventh connecting electrode 247 through the twenty-fourth via V24, which achieves an electrical connection of the first power supply line VDD and the first electrode of the fifth transistor T5. The data signal line DL may be electrically connected with the fifth connecting electrode 245 through the twenty-first via V21. The second initial signal line INIT2 may be electrically connected with the ninth connecting electrode 249 through the twenty-fifth via V25.
Hereto, preparing of the drive circuit layer is completed on the base substrate. In some examples, after the preparing of the drive circuit layer is completed, the light emitting structure layer and the encapsulating structure layer may be sequentially prepared on the drive circuit layer, which will not be repeated here.
In some examples, the first conductive layer 21, the second conductive layer 22, the third conductive layer 23, the fourth conductive layer 24, and the fifth conductive layer 25 may be made of metal materials, such as any one or more of silver (Ag), copper (Cu), aluminum (Al), and molybdenum (Mo), or an alloy material of the above metals, such as an aluminum neodymium alloy (AlNd) or a molybdenum niobium alloy (MoNb), and may be a single-layer structure or a multi-layer composite structure, such as Mo/Cu/Mo, etc.

In some examples, the second insulation layer 12 may be made of a silicon nitride (SiNx), and may be a single layer, a multi-layer, or a composite layer. In this way, a performance of the capacitor can be ensured. The first insulating layer 11, the third insulating layer 13, the fourth insulating layer 14, the fifth insulating layer 15, and the sixth insulating layer 16 may be made of any one or more of a silicon oxide (SiOx) and a silicon oxynitride (SiON), and may be a single layer, a multi-layer, or a composite layer. In some examples, the thickness of the third insulation layer 13 may be about 4000 angstroms. By disposing a relatively thick third insulation layer 13 prepared using a silicon oxide material, an upward permeation of a hydrogen element in the second insulation layer 12 can be blocked, and an influence of the hydrogen element on the characteristics of the oxide thin film transistor can be eliminated.

In some examples, the semiconductor layer 20 may be made of an amorphous indium gallium zinc oxide material (a-IGZO), an indium gallium zinc oxide material (IGZO), a zinc oxide nitride (ZnON), an indium zinc tin oxide (IZTO), or another material, i.e. the present disclosure is applicable to transistors based on Oxide technology.

As can be seen from the structure and the preparing process of the display substrate described above, the first capacitor plate 381 of the capacitor of the exemplary embodiment is located in the first conductive layer 21, the second capacitor plate 382 is located in the second conductive layer 22, and a material of the second insulation layer 12 between the first conductive layer 21 and the second conductive layer 22 may be made of a silicon nitride, thereby ensuring the performance of the capacitor. However, a hydrogen content of the silicon nitride is relatively high, and an intrusion of the hydrogen element into the semiconductor layer will lead to a negative bias of the characteristics of the oxide thin film transistor and deterioration of a negative bias temperature stress (NBTS) reliability, which leads to a relatively large difficulty in debugging of a process of the display substrate. The third insulation layer 13 of the embodiment can block an upward permeation of the hydrogen (H) element in the second insulation layer 12, thereby avoiding an influence of the hydrogen element on the characteristics of the oxide thin film transistor and improving a characteristic stability of the oxide thin film transistor.

The preparation process in the present disclosure may be compatible well with an existing preparation process, which is simple in process implementation, easy to implement, high in production efficiency and yield, and low in production cost.

The structure shown in the aforementioned description in the present disclosure and the preparing process thereof are merely an exemplary description. In an exemplary embodiment, a corresponding structure may be changed and patterning processes may be added or reduced according to an actual need, which is not limited here in the present disclosure. For example, the fifth conductive layer may not be disposed, and the data signal line and the first power supply line may be disposed in the fourth conductive layer.

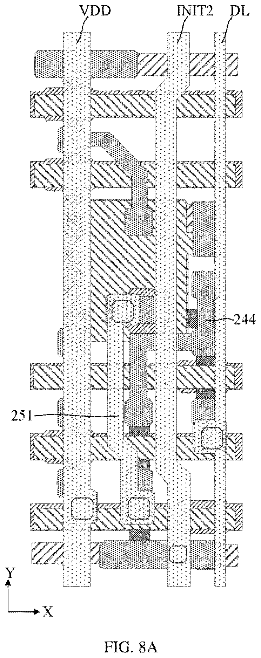

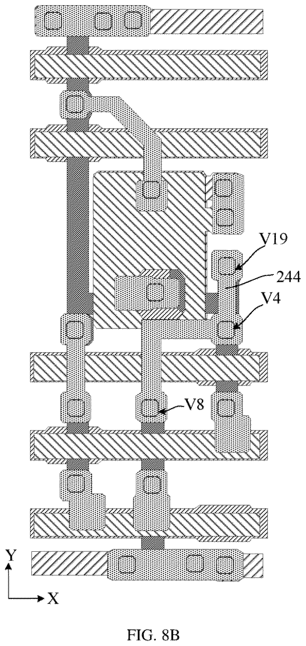

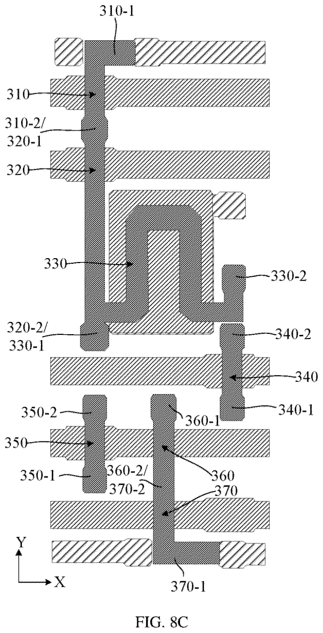

FIG. 8A is another schematic partial top diagram of a drive circuit layer according to at least one embodiment of the present disclosure. In FIG. 8A, an illustration is made by taking one pixel circuit of the drive circuit layer as an example. FIG. 8B is a partially enlarged schematic diagram of the drive circuit layer after the fourth conductive layer is formed in FIG. 8A. FIG. 8C is a partially enlarged schematic diagram of the drive circuit layer after the semiconductor layer is formed in FIG. 8A.

In some examples, as shown in FIG. 8C, the first active layer 310 of the first transistor T1 to the third active layer 330 of the third transistor T3 of the semiconductor layer may be an integral structure connected to each other. The first region 340-1 and the second region 340-2 of the fourth active layer 340 of the fourth transistor T4 may be separately disposed. The second region 330-2 of the third active layer 330 of the third transistor T3 may be disposed separately.

In some examples, as shown in FIGs. 8A to 8C, the fourth connecting electrode 244 located in the fourth conductive layer may be electrically connected with the second region 340-2 of the fourth active layer 340 through the fourth via V4, may also be electrically connected with the first region 360-1 of the sixth active layer 360 through the eighth via V8, and may also be electrically connected with the second region 330-2 of the third active layer 330 through the nineteenth via V19. In this example, an electrical connection of the second electrode of the third transistor T3, the second electrode of the fourth transistor T4, and the first electrode of the sixth transistor T6 is achieved by separately disposing active layers of the third transistor T3 and the fourth transistor T4 and then through the connecting electrode of the fourth conductive layer.

A rest of the structure of the drive circuit layer according to the present embodiment may be referred to descriptions of the aforementioned embodiments, and thus will not be repeated here.

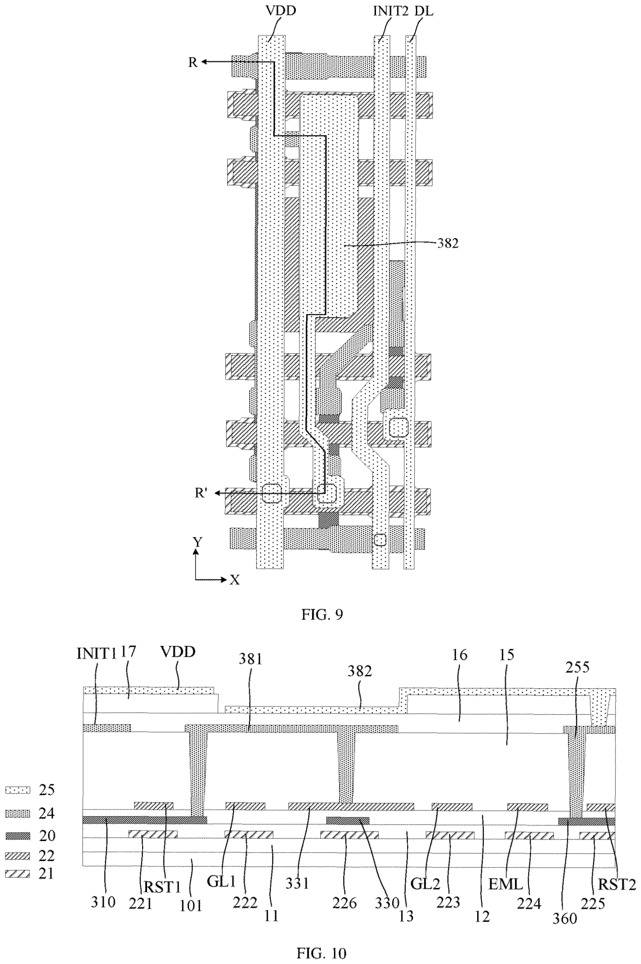

FIG. 9 is another schematic partial top diagram of a drive circuit layer according to at least one embodiment of the present disclosure. In FIG. 9, an illustration is made by taking one pixel circuit of the drive circuit layer as an example. FIG. 10 is a partial sectional view along an R-R' direction in FIG. 9.

In some examples, as shown in FIG. 10, in a direction perpendicular to the display substrate, the drive circuit layer may include: a first conductive layer 21, a semiconductor layer 20, a second conductive layer 22, a fourth conductive layer 24, and a fifth conductive layer 25 that are sequentially disposed on the base substrate 101. In some examples, the fourth conductive layer 24 at least may include: the first capacitor plate 381 of the capacitor, and the fifth conductive layer 25 at least may include: the second capacitor plate of the capacitor. Herein, the first conductive layer 21 may also be referred to as a light shielding (LS) layer, the second conductive layer 22 may also be referred to as a first gate metal (Gate1) layer, the fourth conductive layer 24 may also be referred to as a first source-drain metal (SD1) layer, and the fifth conductive layer 25 may also be referred to as a second source-drain metal (SD2) layer.

In some examples, as shown in FIG. 10, the drive circuit layer may also include: a first insulation layer 11, a third insulation layer 13, a second insulation layer 12, a fifth insulation layer 15, a sixth insulation layer 16, and a seventh insulation layer 17. The first insulation layer 11 may be disposed between the base substrate 101 and the first conductive layer 21, and may also be referred to as a barrier layer. The third insulating layer 13 may be disposed between the first conductive layer 21 and the semiconductor layer 20, and may also be referred to as a buffer layer. The second insulation layer 12 may be disposed between the semiconductor layer 20 and the second conductive layer 22, and may also be referred to as a first gate insulation layer. The fifth insulation layer 15 may be disposed between the second conductive layer 22 and the fourth conductive layer 24, and may also be referred to as an interlayer insulation layer. The sixth insulation layer 16 and the seventh insulation layer 17 may be disposed between the fourth conductive layer 24 and the fifth conductive layer 25, and the sixth insulation layer 16 may be located at a side of the seventh insulation layer 17 close to the base substrate 101. The sixth insulation layer 16 may also be referred to as a passivation (PVX) layer, and the seventh insulation layer 17 may also be referred to as a flat (PLN) layer. In this example, the sixth insulation layer 16 is the aforementioned inorganic insulation layer. In some examples, a material of the first insulation layer 11 to the sixth insulation layer 16 may be an inorganic material, and a material of the seventh insulation layer 17 may be an organic material. However, the embodiment is not limited thereto.

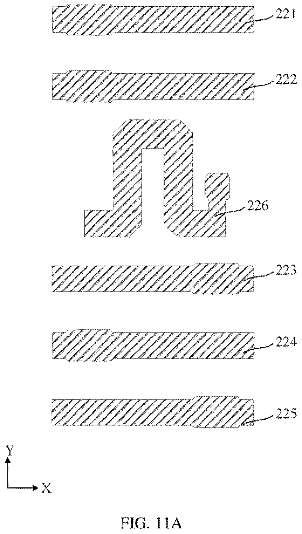

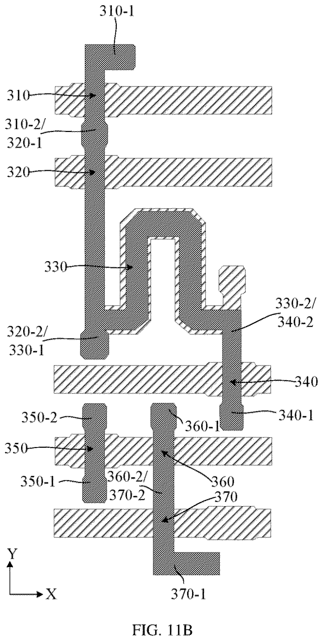

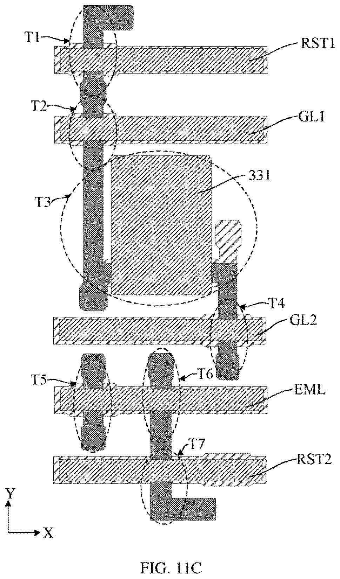

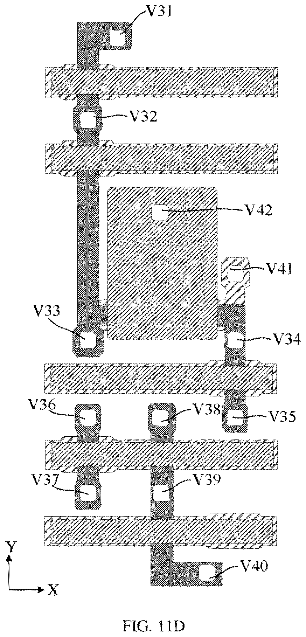

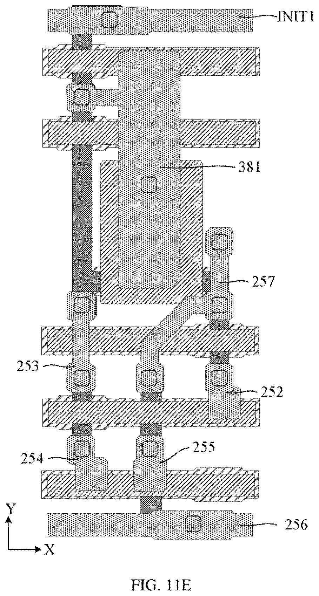

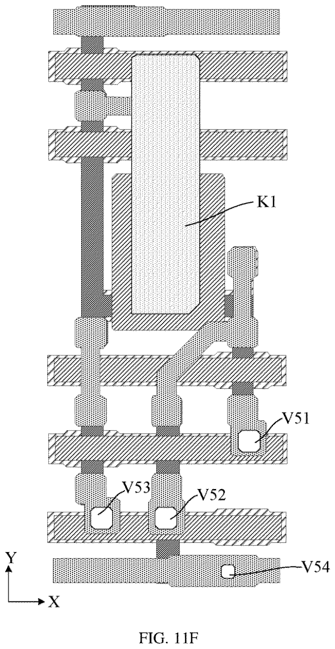

An exemplary description will be given for a structure and a preparing process of the display substrate below with reference to FIGs. 9 to 11F. Herein, FIG. 11A is a partially enlarged schematic diagram of a drive circuit layer after a first conductive layer is formed in FIG. 9. FIG. 11B is a partially enlarged schematic diagram of the drive circuit layer after the semiconductor layer is formed in FIG. 9. FIG. 11C is a partially enlarged schematic diagram of the drive circuit layer after the second conductive layer is formed in FIG. 9. FIG. 11D is a partially enlarged schematic diagram of the drive circuit layer after the fifth insulation layer is formed in FIG. 9. FIG. 11E is a partially enlarged schematic diagram of the drive circuit layer after the fourth conductive layer is formed in FIG. 9. FIG. 11F is a partially enlarged schematic diagram of the drive circuit layer after the seventh insulation layer is formed in FIG. 9.

In some exemplary implementation modes, a preparation process of a display substrate may include following operations. A circuit structure of the pixel circuit of the drive circuit layer may be shown in FIG. 4. Herein, the first transistor T1 to the seventh transistor T7 of the pixel circuit may all be oxide thin film transistors.

(2-1) The base substrate is provided. In some examples, the base substrate 101 may be a rigid base substrate, or may be a flexible base substrate.

(2-2) The first conductive layer is formed.

In some examples, the first insulation thin film and the first conductive thin film are sequentially deposited on the base substrate 101, and the first conductive thin film is patterned by a patterning process to form the first insulation layer 11 and the first conductive layer 21 disposed on the base substrate 101. As shown in FIG. 11A, the first conductive layer 21 may at least include: a first light shielding electrode 226, and the first trace 221 to the fifth trace 225. The first trace 221 to the fifth trace 225 may all extend along the first direction X. The first trace 221 and the second trace 222 may be located at a side of the first light shielding electrode 226 in the second direction Y, and the third trace 223 to the fifth trace 225 may be located at another side of the first light shielding electrode 226 in the second direction Y. An orthographic projection of the first light shielding electrode 226 on the base substrate 101 may be substantially n-shaped.

(2-3) The semiconductor layer is formed.

In some examples, the third insulation thin film and the semiconductor thin film are sequentially deposited on the base substrate 101 on which the aforementioned patterns are formed, and the semiconductor thin film is patterned by a patterning process to form the third insulation layer 13 and the semiconductor layer 20 covering the first conductive layer 21. As shown in FIG. 11B, the semiconductor layer 20 may at least include: the first active layer 310 of the first transistor T1 to the seventh active layer 370 of the seventh transistor T7. The first active layer 310 of the first transistor T1 to the fourth active layer 340 of the fourth transistor T4 may be an integral structure connected to each other. The sixth active layer 360 of the sixth transistor T6 and the seventh active layer 370 of the seventh transistor T7 may be an integral structure. The fifth active layer 350 of the fifth transistor T5 may be located at a side of the sixth active layer 360 away from the fourth active layer 340 in the second direction Y. However, the embodiment is not limited thereto. For example, the fourth active layer 340 of the fourth transistor T4 may be independently disposed.

(2-4) The second conductive layer is formed.

In some examples, the second insulating thin film and the second conductive thin film are sequentially deposited on the base substrate 101 on which the aforementioned patterns are formed, and the second conductive thin film is patterned by a patterning process to form the second insulating layer 12 covering the semiconductor layer 20 and the second conductive layer 22 disposed on the second insulating layer 12. As shown in FIG. 11C, the second conductive layer 22 may at least include: the first scan signal line GL1, the second scan signal line GL2, the third scan signal line RST1, the fourth scan signal line RST2, the light emitting control line EML, and the gate 331 of the third transistor T3. The first scan signal line GL1 to the fourth scan signal line RST2 and the light emitting control line EML may all extend along the first direction X. The orthographic projection of the gate 331 of the third transistor T3 on the base substrate 101 may be a rectangle, for example, may be a rounded rectangle.

In some examples, as shown in FIG. 11C, an overlapping region of the third scan signal line RST1 and the first active layer 310 may serve as the gate of the first transistor T1, an overlapping region of the first scan signal line GL1 and the second active layer 320 may serve as the gate of the second transistor T2, an overlapping region of the second scan signal line GL2 and the fourth active layer 340 may serve as the gate of the fourth transistor T4, an overlapping region of the light emitting control line EML and the fifth active layer 350 may serve as the gate of the fifth transistor T5, an overlapping region of the light emitting control line EML and the sixth active layer 360 may serve as the gate of the sixth transistor T6, and an overlapping region of the fourth scan signal line RST2 and the seventh active layer 370 may serve as the gate of the seventh transistor T7.

In some examples, as shown in FIG. 11B, the orthographic projection of the first light shielding electrode 226 on the base substrate 101 may be overlapped with the orthographic projection of the channel region of the active layer 330 of the third transistor T3 on the base substrate 101. The orthographic projection of the first trace 221 on the base substrate 101 may cover the orthographic projection of the channel region of the active layer 310 of the first transistor T1 on the base substrate 101. The orthographic projection of the second trace 222 on the base substrate 101 may cover an orthographic projection of a channel region of the active layer 320 of the second transistor T2 on the base substrate 101. The orthographic projection of the third trace 223 on the base substrate 101 may cover an orthographic projection of a channel region of the active layer 340 of the fourth transistor T4 on the base substrate 101. The orthographic projection of the fourth trace 224 on the base substrate 101 may cover orthographic projections of a channel region of the active layer 350 of the fifth transistor T5 and a channel region of the active layer 360 of the sixth transistor T6 on the base substrate 101. The orthographic projection of the fifth trace 225 on the base substrate 101 may cover an orthographic projection of a channel region of the active layer 370 of the seventh transistor T7 on the base substrate 101.

(2-5) The fifth insulation layer is formed.

In some examples, the fifth insulation thin film is deposited on the base substrate 101 on which the aforementioned patterns are formed, and the fifth insulation thin film is patterned through a patterning process to form the fifth insulation layer 15 disposed on the base substrate 101. As shown in FIG. 11D, the fifth insulating layer 15 is provided with multiple vias, which may include, for example, a thirty-first via V31 to a forty-second via V42. The fifth insulating layer 15 and the second insulating layer 12 within the thirty-first via V31 to the fortieth via V40 are removed to expose a surface of the semiconductor layer 20. The fifth insulation layer 15, the second insulation layer 12, and the third insulation layer 13 within the forty-first via V41 are removed to expose a surface of the first conductive layer 21. The fifth insulating layer 15 within the forty-second via V42 is removed to expose a surface of the second conductive layer 22.

(2-6) The fourth conductive layer is formed.

In some examples, the fourth conductive thin film is deposited on the base substrate 101 on which the aforementioned patterns are formed, and the fourth conductive thin film is patterned through a patterning process to form the fourth conductive layer 24 disposed on the base substrate 101. As shown in FIG. 11E, the fourth conductive layer 24 may at least include: the first capacitor plate 381 of the capacitor, the first initial signal line INIT1, and multiple connecting electrodes (e.g. a twelfth connecting electrode 252 to a seventeenth connecting electrode 257).

In some examples, as shown in FIG. 11E, the orthographic projection of the first capacitor plate 381 of the capacitor on the base substrate 101 may be overlapped with orthographic projections of the gate 331 of the third transistor T3 and the channel region of the active layer 330 on the base substrate 101. As shown in FIGs. 11D and 11E, the first capacitor plate 381 of the capacitor may be electrically connected with the second region 310-2 of the active layer 310 of the first transistor T1 through the thirty-second via V32, and may also be electrically connected with the gate 331 of the third transistor T3 through the forty-second via V42. The first initial signal line INIT1 may be electrically connected with the first region 310-1 of the active layer 310 of the first transistor T1 through the thirty-first via V31. The seventeenth connecting electrode 257 may be electrically connected with the second region 340-2 of the active layer 340 of the fourth transistor T4 through the thirty-fourth via V34, may also be electrically connected with the first region 360-1 of the active layer 360 of the sixth transistor T6 through the thirty-eighth via V38, and may also be electrically connected with the first light shielding electrode 226 through the forty-first via V41. In this example, the first light shielding electrode 226 and the gate 331 of the third transistor T3 may form an auxiliary capacitor to ensure characteristics of the third transistor. The twelfth connecting electrode 252 may be electrically connected with the first region 340-1 of the active layer 340 of the fourth transistor T4 through the thirty-fifth via V35. The thirteenth connecting electrode 253 may be electrically connected with the second region 320-2 of the active layer 320 of the second transistor T2 through the thirty-third via V33, and may also be electrically connected with the second region 350-2 of the active layer 350 of the fifth transistor T5 through the thirty-sixth via V36. The fourteenth connecting electrode 254 may be electrically connected with the first region 350-1 of the active layer 350 of the fifth transistor T5 through the thirty-seventh via V37. The fifteenth connecting electrode 255 may be electrically connected with the second region 360-2 of the active layer 360 of the sixth transistor T6 through the thirty-ninth via V39. The sixteenth connecting electrode 256 may be electrically connected with the first region 370-1 of the active layer 370 of the seventh transistor T7 through the fortieth via V40.

(2-7) The sixth insulation layer and the seventh insulation layer are formed.

In some examples, the sixth insulation thin film is deposited on the base substrate 101 on which the aforementioned patterns are formed, and then the seventh insulation thin film is coated, and the seventh insulation thin film and the sixth insulation thin film are patterned through a patterning process to form the sixth insulation layer 16 and the seventh insulation layer 17. In some examples, the sixth insulation layer 16 may be further etched within a via or a groove of the seventh insulation layer 17 after the via or the groove is formed on the seventh insulation layer 17 to form a via or a groove located on the sixth insulation layer 16 and expose a surface of the fourth conductive layer 24. For example, as shown in FIG. 11F, the seventh insulation layer 17 may be provided with a fifty-first via V51 to a fifty-fourth via V54 and a first groove K1. The seventh insulation layer 17 in the first groove is removed to expose a surface of the sixth insulation layer 16. An orthographic projection of the first groove K1 on the base substrate 101 is overlapped with the orthographic projection of the first capacitor plate 381 on the base substrate 101. For example, the orthographic projection of the first groove K1 on the base substrate 101 may be located within a range of the orthographic projection of the first capacitor plate 381 on the base substrate 101. The seventh insulating layer 17 and the sixth insulating layer 16 within the fifty-first via V51 to the fifty-fourth via V54 are removed to expose a surface of the fourth conductive layer 24.

(2-8) The fifth conductive layer is formed.

In some examples, the fifth insulation thin film is deposited on the base substrate 101 on which the aforementioned patterns are formed, and the fifth insulation thin film is patterned through a patterning process to form the fifth conductive layer 25. As shown in FIG. 9, the fifth conductive layer 25 may include: the second capacitor plate 382, the first power supply line VDD, the second initial signal line INIT2, and the data signal line DL. The first power supply line VDD, the second initial signal line INIT2, and the data signal line DL may all extend along the second direction Y. The second initial signal line INIT2 may be located between the first power supply line VDD and the data signal line DL in the first direction X. The second capacitor plate 382 may be located between the first power supply line VDD and the second initial signal line INIT2 in the first direction X.

In some examples, as shown in FIGs. 11F and 9, the second capacitor plate 382 may be electrically connected with the fifteenth connecting electrode 255 through the fifty-second via V52, thereby achieving an electrical connection of the second capacitor plate 382 and the second electrode of the sixth transistor T6. An overlapping region of the second capacitor plate 382 and the first capacitor plate 381 on the base substrate 101 may be located within a range of the orthographic projection of the first groove K1 on the base substrate 101. In this example, only the sixth insulation layer 16 using an inorganic material (e.g. a silicon nitride) is disposed in the overlapping region between the first capacitor plate 381 and the second capacitor plate 382, which can ensure a performance of the capacitor. The overlapping region of the first capacitor plate 381 and the second capacitor plate 382 may be overlapped with both of the orthographic projections of the gate 331 of the third transistor T3 and the channel region of the active layer 330 on the base substrate 101. The second capacitor plate 382 may also subsequently be electrically connected with the anode of the light emitting element.

In some examples, as shown in FIGs. 11F and 9, the first power supply line VDD may be electrically connected with the fourteenth connecting electrode 254 through a fifty-third via V53 to achieve an electrical connection of the first power supply line VDD and the first electrode of the fifth transistor T5. The data signal line DL may be electrically connected with the twelfth connecting electrode 252 through a fifty-first via V51, thereby achieving an electrical connection of the data signal line DL and the first electrode of the fourth transistor T4. The second initial signal line INIT2 may be electrically connected with the sixteenth connection electrode 256 through a fifty-fourth via V54.

Hereto, preparing of the drive circuit layer is completed on the base substrate. In some examples, after the preparing of the drive circuit layer is completed, the light emitting structure layer and the encapsulating structure layer may be sequentially prepared on the drive circuit layer, which will not be repeated here.

In some examples, the sixth insulation layer 16 may be made of a silicon nitride (SiNx), and may be a single layer, a multi-layer, or a composite layer. In this way, the performance of the capacitor can be ensured. The first insulation layer 11, the third insulation layer 13, the second insulation layer 12, and the fifth insulation layer 15 may be made of any one or more of a silicon oxide (SiOx) and a silicon oxynitride (SiON), and may be a single layer, a multi-layer, or a composite layer. In some examples, a thickness of the fifth insulation layer 15 may be about 5000 angstroms, and a thickness of the second insulation layer 12 may be greater than or equal to 1000 angstroms, for example, may be about 1000 angstroms. By disposing relatively thick fifth insulation layer 15 and second insulation layer 12 prepared using a silicon oxide material, a downward permeation of a hydrogen element in the sixth insulation layer 16 can be blocked, and an influence of the hydrogen element on the characteristics of the oxide thin film transistor can be eliminated.

A rest of the description of the display substrate according to the embodiment may refer to descriptions of the aforementioned embodiments, and thus will not be repeated here.

As can be seen from the structure and the preparing process of the display substrate described above, the first capacitor plate 381 and the second capacitor plate 382 of the capacitor of the exemplary embodiment may be located in the fourth conductive layer 24 and the fifth conductive layer 25, respectively, and the sixth insulation layer 16 between the fourth conductive layer 24 and the fifth conductive layer 25 may be made of a silicon nitride, which can ensure the performance of the capacitor. Compared with the previous embodiment, in the embodiment, the third conductive layer and the fourth insulation layer are removed, which can block the downward permeation of the hydrogen (H) element in the sixth insulation layer 16, thereby avoiding the influence of the hydrogen element on the characteristics of the oxide thin film transistor and improving the characteristic stability of the oxide thin film transistor.

The embodiment also provides a method for preparing a display substrate, which is used for preparing the display substrate as described above. The preparing method includes: forming a drive circuit layer on a base substrate, wherein the drive circuit layer includes at least one pixel circuit, and the at least one pixel circuit includes at least one oxide thin film transistor and a capacitor; the capacitor includes a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate; a distance between the inorganic insulation layer and an active layer of the oxide thin film transistor is greater than or equal to 3000 angstroms in a direction perpendicular to the display substrate.

The method for preparing the display substrate in the embodiment may refer to the description of the aforementioned embodiments, and thus will not be repeated here.

The embodiment also provides a display apparatus, including the display substrate as described above.

In some exemplary implementations, the display substrate may be a flexible OLED display substrate, a QLED display substrate, a Micro-LED display substrate, or a Mini-LED display substrate. The display device may be any product or component with a display function such as an OLED display, a cell phone, a tablet, a television, a display, a laptop, a digital photo frame, a navigator, and so on, which is not limited in the embodiments of the present disclosure.

The drawings of the present disclosure only relate to structures involved in the present disclosure, and other structures may refer to conventional designs. The embodiments in the present disclosure, i.e., features in the embodiments, may be combined with each other to obtain new embodiments if there is no conflict. Those of ordinary skills in the art should understand that modifications or equivalent replacements of the technical solutions of the present disclosure may be made without departing from the spirit and scope of the technical solutions of the present disclosure, and shall all fall within the scope of the claims of the present disclosure.

**Claims**

1. A display substrate, comprising: a base substrate and a drive circuit layer disposed on the base substrate, wherein the drive circuit layer comprises at least one pixel circuit, and the at least one pixel circuit comprises at least one oxide thin film transistor and a capacitor;

   the capacitor comprises a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate; and
   in a direction perpendicular to the display substrate, a distance between the inorganic insulation layer and an active layer of the oxide thin film transistor is greater than or equal to 3000 angstroms.

2. The display substrate of claim 1, wherein a material of the active layer of the oxide thin film transistor comprises an indium gallium zinc oxide material.

3. The display substrate of claim 1 or 2, wherein a material of the inorganic insulation layer comprises a silicon nitride SiNx.

4. The display substrate of any one of claims 1 to 3, wherein the pixel circuit comprises a drive transistor, the first capacitor plate of the capacitor is equipotential to a gate of the drive transistor, and the second capacitor plate of the capacitor is electrically connected with an anode of a light emitting element.

5. The display substrate of any one of claims 1 to 4, wherein the drive circuit layer comprises at least: a first conductive layer, a second conductive layer, and a semiconductor layer sequentially disposed on the base substrate;

   the semiconductor layer comprises: an active layer of the at least one oxide thin film transistor;
   the first conductive layer at least comprises: the first capacitor plate; and
   the second conductive layer at least comprises: the second capacitor plate.

6. The display substrate of claim 5, wherein the first conductive layer is a light shielding layer.

7. The display substrate of claim 5 or 6, wherein a third insulating layer is disposed between the second conductive layer and the semiconductor layer, wherein a material of the third insulating layer comprises a silicon oxide SiOx, and a thickness of the third insulating layer is substantially 3500 angstroms to 4500 angstroms.

8. The display substrate of any one of claims 5 to 7, wherein the drive circuit layer further comprises: a third conductive layer located at a side of the semiconductor layer away from the base substrate, wherein the third conductive layer comprises a gate of the at least one oxide thin film transistor.

9. The display substrate of any one of claims 1 to 4, wherein the drive circuit layer comprises:
a semiconductor layer, a second conductive layer, a fourth conductive layer, and a fifth conductive layer sequentially disposed on the base substrate;

   the semiconductor layer comprises: an active layer of the at least one oxide thin film transistor;
   the second conductive layer comprises: a gate of the at least one oxide thin film transistor;
   the fourth conductive layer at least comprises: the first capacitor plate; and
   the fifth conductive layer at least comprises: the second capacitor plate.

10. The display substrate of claim 9, wherein a fifth insulation layer is disposed between the fourth conductive layer and the second conductive layer, wherein a material of the fifth insulation layer comprises a silicon oxide SiOx, and a thickness of the fifth insulation layer is substantially 4500 angstroms to 5500 angstroms.

11. The display substrate of claim 9 or 10, wherein the drive circuit layer further comprises: a first conductive layer located at a side of the semiconductor layer close to the base substrate; and
the first conductive layer comprises: at least one light shielding electrode, wherein an orthographic projection of the light shielding electrode on the base substrate covers an orthographic projection of a channel region of the active layer of the oxide thin film transistor on the base substrate.

12. The display substrate of any one of claims 9 to 11, wherein the inorganic insulation layer and an organic insulation layer are disposed between the fourth conductive layer and the fifth conductive layer, wherein the inorganic insulation layer is located at a side of the organic insulation layer close to the base substrate; and
an overlapping region of the first capacitor plate and the second capacitor plate is not overlapped with an orthographic projection of the organic insulation layer on the base substrate.

13. The display substrate of any one of claims 9 to 12, wherein the fifth conductive layer further comprises: a data signal line and a first power supply line.

14. The display substrate of any one of claims 1 to 13, wherein the at least one oxide thin film transistor comprises a drive transistor; a gate of the drive transistor is electrically connected with the first capacitor plate of the capacitor; and an orthographic projection of a channel region of an active layer of the drive transistor on the base substrate is overlapped with each of orthographic projections of the first capacitor plate and the second capacitor plate of the capacitor on the base substrate.

15. A display apparatus, comprising the display substrate of any one of claims 1 to 14.

16. A method for preparing a display substrate, used for preparing the display substrate of any one of claims 1 to 14, wherein the method for preparing comprises:
forming a drive circuit layer on a base substrate, wherein the drive circuit layer comprises at least one pixel circuit, and the at least one pixel circuit comprises at least one oxide thin film transistor and a capacitor; the capacitor includes a first capacitor plate and a second capacitor plate, wherein orthographic projections of the first capacitor plate and the second capacitor plate on the base substrate are overlapped, and an inorganic insulation layer is disposed between the first capacitor plate and the second capacitor plate; and a distance between the inorganic insulation layer and an active layer of the oxide thin film transistor is greater than or equal to 3000 angstroms in a direction perpendicular to the display substrate.

FIG. 1

FIG. 2

302 301 303 304 401 402 403

104 {

103 {

102 {

101

FIG. 3

VDD

GL1
T5
EML

T2
N2

GL2

N1
T3

N3
T4
DL

T6
EML

RST1
T1
C
N4
T7
INIT2

EL
RST2

INIT1

VSS

FIG. 4

FIG. 5

VDD  242  15  GL1          17          331  16  VDD  246

25
24
23
20
22
21

310  11  12  222  13  14  101  381  382  330

FIG. 6A

15  331  INIT2  250  331  16  17  GL2  251  EML  248  RST2

25
24
23
20
22
21

101  381  330  382  11  12  223  13  224  14  360  225

FIG. 6B

211    212

3811 381    3812

213    214

Y

X

FIG. 7A

FIG. 7B

FIG. 7C

FIG. 7D

FIG. 7E

FIG. 7F

VDD INIT2 DL

244

251

Y

X

FIG. 8A

FIG. 8B

FIG. 8C

VDD          INIT2 DL

R ◄

382

R'

Y
└─► X

FIG. 9

INIT1 17   VDD      381        382           16     15      255

▦ 25
▦ 24
▬ 20
▨ 22
▨ 21

RST1     GL1      331           GL2     EML     RST2

310  221   101   222     226   330   223      224    225
                 11             13         12     360

FIG. 10

221

222

226

223

224

225

Y

X

FIG. 11A

FIG. 11B

FIG. 11C

FIG. 11D

INIT1

381

257

253

252

254

255

256

Y

X

FIG. 11E

FIG. 11F

## INTERNATIONAL SEARCH REPORT

| International application No. |
|---|
| **PCT/CN2022/098636** |

**A. CLASSIFICATION OF SUBJECT MATTER**

H01L 27/32(2006.01)i; H01L 51/50(2006.01)i; H01L 51/52(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS; CNTXT; CNKI; VEN; WOTXT; EPTXT; USTXT: 显示基板, 显示装置, 衬底, 驱动电路, 像素电路, 氧化物, 薄膜晶体管, 电容, 第一, 第二, 电极, 极板, 无机, 绝缘层, 有源层, 距离, display panel, display device, substrate, driv+ circuit, pixel circuit, oxide, thin film transistor, TFT, capacitor, first, second, electrode, inorganic, insulating layer, active layer, space

**C. DOCUMENTS CONSIDERED TO BE RELEVANT**

| Category* | Citation of document, with indication, where appropriate, of the relevant passages | Relevant to claim No. |
|---|---|---|
| X | CN 111771283 A (APPLIED MATERIALS INC.) 13 October 2020 (2020-10-13) description, paragraphs [0027]-[0066], and figures 1-9B | 1-16 |
| X | CN 113241358 A (HEFEI VISIONOX TECHNOLOGY CO., LTD.) 10 August 2021 (2021-08-10) description, paragraphs [0028]-[0059], and figures 1-7 | 1-16 |
| X | CN 113097232 A (HEFEI VISIONOX TECHNOLOGY CO., LTD.) 09 July 2021 (2021-07-09) description, paragraphs [0048]-[0086], and figures 1-8 | 1-16 |
| X | CN 112234091 A (XIAMEN TIANMA MICRO-ELECTRONICS CO., LTD.) 15 January 2021 (2021-01-15) description, paragraphs [0040]-[0109], and figures 1-25 | 1-16 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 December 2022** | **18 January 2023** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/098636**

| Patent document cited in search report | | | Publication date (day/month/year) | Patent family member(s) | | | Publication date (day/month/year) |
|---|---|---|---|---|---|---|---|
| CN | 111771283 | A | 13 October 2020 | KR | 20200098723 | A | 20 August 2020 |
| | | | | TW | 201941180 | A | 16 October 2019 |
| | | | | US | 2021376032 | A1 | 02 December 2021 |
| | | | | JP | 2021510426 | A | 22 April 2021 |
| | | | | WO | 2019140007 | A1 | 18 July 2019 |
| | | | | US | 2019214447 | A1 | 11 July 2019 |
| | | | | US | 11101338 | B2 | 24 August 2021 |
| CN | 113241358 | A | 10 August 2021 | None | | | |
| CN | 113097232 | A | 09 July 2021 | None | | | |
| CN | 112234091 | A | 15 January 2021 | US | 2021134917 | A1 | 06 May 2021 |
| | | | | CN | 214336718 | U | 01 October 2021 |

Form PCT/ISA/210 (patent family annex) (January 2015)